(19) Europäisches Patentamt
European Patent Office
Office européen des brevets

(11) **EP 4 363 096 B1**

(12) **EUROPÄISCHE PATENTSCHRIFT**

(45) Veröffentlichungstag und Bekanntmachung des Hinweises auf die Patenterteilung:
**25.09.2024 Patentblatt 2024/39**

(21) Anmeldenummer: **21844235.8**

(22) Anmeldetag: **20.12.2021**

(51) Internationale Patentklassifikation (IPC):
***B01J 8/10*** (2006.01)  ***B01J 19/00*** (2006.01)

(52) Gemeinsame Patentklassifikation (CPC):
**B01J 8/10; B01J 19/0066;** B01J 2208/00867

(86) Internationale Anmeldenummer:
**PCT/EP2021/086901**

(87) Internationale Veröffentlichungsnummer:
**WO 2023/117048 (29.06.2023 Gazette 2023/26)**

(54) **KONTAKTIERUNG VON FEINEN PARTIKELN MIT EINER GASPHASE IN EINEM RÜHRBETTREAKTOR**

CONTACTING FINE PARTICLES WITH A GAS PHASE IN A STIRRED BED REACTOR

MISE EN CONTACT DE FINES PARTICULES AVEC UNE PHASE GAZEUSE DANS UN RÉACTEUR À LIT AGITÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.05.2024 Patentblatt 2024/19**

(73) Patentinhaber: **Wacker Chemie AG**
**81671 München (DE)**

(72) Erfinder:
• **TILLMANN, Jan**
**80636 München (DE)**
• **DRÄGER, Christoph**
**81369 München (DE)**
• **FRICKE, Michael**
**84489 Burghausen (DE)**
• **KALYAKINA, Alena**
**81379 München (DE)**
• **KNEISSL, Sebastian**
**83059 Kolbermoor (DE)**

(74) Vertreter: **Belz, Ferdinand et al**
**Wacker Chemie AG**
**Gisela-Stein-Straße 1**
**81671 München (DE)**

(56) Entgegenhaltungen:
EP-A1- 0 000 512  WO-A1-2021/165923
WO-A1-2022/084545  DE-A1- 19 901 305
DE-A1- 2 552 881  US-A- 3 791 435

**Beschreibung**

Die Erfindung betrifft ein Verfahren zur Herstellung von Produkten durch Kontaktierung von Partikeln in einem gerührten Festbett mit einer Gasphase, wobei die Behandlung der Partikel in der Prozesszone eines gasdurchströmten Reaktors stattfindet und die Partikel mittels eines wandgängigen Rührers während der Kontaktierung mit der Gasphase in der Prozesszone umgewälzt werden, wobei das Rührwerk wandgängig ist.

Reaktionen von Gasphasen an Festkörperoberflächen sind aus der heutigen Welt nicht wegzudenken. Beispielsweise findet eine Abgasbehandlung von Verbrennungsmotoren an der Oberfläche von Rhodiumkatalysatoren statt. Auch in der chemischen Industrie werden viele Reaktionen zwischen Gasen und Feststoffoberflächen durchgeführt. Dazu ist es im Allgemeinen von großer Wichtigkeit, dass möglichst viel Feststoffoberflächen mit einem Gas kontaktiert werden können, damit diese Reaktionen effizient und mit einer hohen Raum-Zeitausbeute durchgeführt werden können. Allgemein wurden in der Vergangenheit verschiedene Verfahren entwickelt, um Festkörper mit einem Gas in Kontakt bringen zu können. Diese Prozesse unterscheiden sich dabei vor allem in der Morphologie der eingesetzten Feststoffe. Dabei steigt der technische Anspruch immer weiter an, je kleiner die eingesetzten Partikel sind und desto höher die nutzbare Feststoffoberfläche im Prozess ist.

Zur Durchführung von Gas-Feststoff-Reaktionen sind mehrere Reaktortypen für die kommerzielle Anwendung bekannt. FBR (fluidized bed reactor) und Drehrohrofen haben beispielsweise den Nachteil, nicht für alle Partikelgrößen einsetzbar zu sein. Speziell für sehr feine Partikel sind Reaktionen mit einer Gasphase nicht ohne erheblichen technischen Aufwand möglich. Partikel der Geldart-Klasse C können mit den verfügbaren Methoden nicht behandelt werden. Partikel der Geldart-Klasse C zeichnen sich durch ihre geringe Größe aus ($d_{90}$ <20 $\mu$m) und zeigen starke interpartikuläre Anziehungskräfte, welche eine saubere Fluidisierung erschweren. Typische Beispiele sind Mehl oder feine Stäube, etwa Abrieb von Feststoffhandhabungen. In schlanken Reaktoren neigen diese Partikelbetten zu starker Blasenbildung mit Anheben des gesamten darüber befindlichen Partikelbetts. In flachen Wirbelbetten kann es zur Kamin- oder Tunnelbildung zwischen Verteilboden und Bettoberfläche kommen, so dass die anderen Bereiche des Partikelbetts nicht mehr in gleicherweise mit der Gasphase durchströmt werden [D. Geldart, Types of gas fluidization, Powder Technology 7 (1973) 258]. Eine gute Fluidisierung von solchen Partikeln kann daher meist nur mit mechanischem Energieeintrag durch Rührer oder Vibratoren erreicht werden.

Es ist allgemein bekannt, dass bei mehrphasigen Reaktionssystemen, umfassend mindestens eine Schüttung aus Partikeln, eine gute Kontaktierung des porösen Feststoffs mit dem fluiden Präkursor notwendig ist [F. Schüth Chem. Unserer Zeit 2006, 40, 92-103].

Als Beispiel für solche Verfahren, kann die Herstellung von Silicium-Kohlenstoff-Kompositen zur Verwendung in Lithium-Ionen-Akkumulatoren beschrieben werden.

Beispielsweise beschreibt die US 10,147,950 B2 die Abscheidung von Silicium aus Monosilan $SiH_4$ in einem porösen Kohlenstoff in einem Drehrohrofen oder vergleichbaren Ofentypen bei erhöhten Temperaturen von 300 bis 900°C, bevorzugt unter Bewegung der Partikel, durch einen CVD- ("chemical vapor deposition") oder PE-CVD-Prozess ("plasma-enhanced chemical vapor deposition"). Dabei kommt eine Mischung von 2 mol-% Monosilan mit Stickstoff als Inertgas zum Einsatz. Die geringe Konzentration des Silicium-Präkursors im Gasgemisch führt dabei zu sehr langen Reaktionszeiten. Zudem ist das Verhältnis von Schüttung zu Reaktorvolumen in einem Drehrohrofen meist sehr ungünstig, da es ansonsten zu einem erheblichen Partikelaustrag durch den Gasstrom kommt.

Eine weitere Methode für die Durchführung von Gas-Feststoff-Reaktionen sind Gaswirbelschichten.

In einer Gaswirbelschicht wird eine Schüttung aus Feststoffpartikeln durch ein aufwärts strömendes Gas so weitgehend aufgelockert und getragen, dass die Feststoffschicht als Ganzes flüssigkeitsähnliches Verhalten zeigt [VDI-Wärmeatlas, 11. Auflage, Abschnitt L3.2 Strömungsformen und Druckverlust in Wirbelschichten, S. 1371 - 1382, Springer Verlag, Berlin Heidelberg, 2013].

Gaswirbelschichten werden allgemein auch als Wirbelschichten oder auch als Wirbelbetten bezeichnet. Der Vorgang zur Erzeugung einer Wirbelschicht wird auch als Fluidisierung oder Fluidisieren bezeichnet.

In einer Gaswirbelschicht liegen die Feststoffpartikel sehr gut dispergiert vor. Folglich bildet sich eine sehr große Kontaktfläche zwischen Feststoff und Gas aus, die ideal für Energie- und Stoffaustauschprozesse genutzt werden kann. Gaswirbelschichten sind generell durch sehr gute Stoff- und Wärmeübergangsvorgänge und durch eine gleichmäßige Temperaturverteilung charakterisiert. Die Güte der Stoff- und Wärmeübergangsprozesse ist insbesondere für die Homogenität von durch Reaktionen in Wirbelschichten erhaltenen Produkten entscheidend und lässt sich mit der Homogenität des Fluidisierungszustands korrelieren. Folglich ist die Ausbildung einer homogenen Wirbelschicht bzw. eines homogenen Fluidisierungszustands essenziell für die Nutzung des Wirbelschichtprozesses zur Herstellung von Produkten mit gleichen Produkteigenschaften.

In Abhängigkeit von der Partikelgröße und der Feststoffdichte der Partikel können die Fluidisierungseigenschaften klassifiziert werden. Beispielsweise fallen Partikel mit einer Partikelgröße $d_{90} < 20$ $\mu$m und mit einer Dichtedifferenz zwischen Partikel und Gas > 1000 kg/m$^3$ in die Geldart-Klasse C (kohäsiv) [D. Geldart, Types of gas fluidization, Powder Technology 7 (1973) 258]. Partikel der Geldart-Klasse C sind dadurch gekennzeichnet, dass sie schlecht in einen fluidisierten Zustand überführt werden können. Aufgrund ihrer geringen Partikelgröße ist der Einfluss der interpartikulären Anziehungskräfte in der gleichen Größenordnung oder größer als die durch die Gasströmung auf die primären Partikel einwirkenden Kräfte.

Entsprechend treten Effekte wie die Anhebung des Wirbelbettes als Ganzes und/oder Kanalbildung auf. Bei der Kanalbildung bilden sich anstelle einer Wirbelschicht Röhren in der Partikelschüttung aus, durch die das Fluidisiergas bevorzugt strömt, während der größte Teil der Schüttung gar nicht durchströmt wird. Dadurch wird keine Homogenität der Fluidisierung erreicht. Wird die Gasgeschwindigkeit deutlich über die minimale Fluidisierungsgeschwindigkeit der primären Partikel der Schüttung erhöht, so bilden sich mit der Zeit Agglomerate bestehend aus Einzelpartikeln aus, die vollständig oder teilweise fluidisiert werden können. Ein typisches Verhalten ist die Ausbildung von Schichten mit Agglomeraten unterschiedlicher Größe. In der untersten Schicht direkt über dem Anströmboden befinden sich dabei sehr große Agglomerate, die sehr wenig bis keine Bewegung aufweisen. In der darüber liegenden Schicht befinden sich kleinere Agglomerate, die fluidisiert sind. In der obersten Schicht liegen die kleinsten Agglomerate vor, die teilweise von der Gasströmung mitgerissen werden, was verfahrenstechnisch problematisch ist. Das Fluidisierungsverhalten derartiger Partikelschüttungen ist zusätzlich durch Bildung von großen Gasblasen und einer geringen Expansion des Wirbelbetts gekennzeichnet. In der englischsprachigen Literatur wird dieses Verhalten als "agglomerate bubbling fluidization" (ABF) bezeichnet. [Shabanian, J.; Jafari, R.; Chaouki, J., Fluidization of Ultrafine Powders, IRECHE., Vol.4, N.1, 16-50].

Dem Fachmann ist klar, dass ABF-Wirbelschichten aufgrund der Inhomogenitäten innerhalb des Wirbelbetts und der damit verbundenen inhomogenen Stoff- und Wärmeübergangsbedingungen für die Produktion von Stoffen mit homogenen Eigenschaften ungeeignet sind.

Aus diesem Grund werden in GB 2580110 B2 beispielsweise Partikel mit einer Größe ($d_{50}$) von mehr als 50 $\mu$m in einer Wirbelschicht mit 1,25 Vol.-% Monosilan fluidisiert. Die so erhaltenen Partikel müssen nach der Beendigung der Reaktion allerdings auf die benötigte Zielgröße von < 20 $\mu$m vermahlen werden. Die Fluidisierung von Partikeln < 20 $\mu$m würde in dieser Wirbelschicht zu starken Agglomerationen und einer inhomogenen Infiltration der porösen Kohlenstoffpartikel führen.

Es sind Fluidisierhilfsmittel bekannt, um Partikel < 20 $\mu$m in Form von Agglomeraten in eine überwiegend homogene Wirbelschicht zu überführen. In der US 7,658,340 B2 wird beispielsweise beschrieben, dass durch den Eintrag weiterer Kraftkomponenten wie Vibrationskräfte, magnetische Kräfte, akustische Kräfte, Rotations- bzw. Zentrifugalkräfte oder Kombinationen davon neben der Krafteinwirkung durch das Fluidisierungsgas die Größe der Agglomerate bestehend aus $SiO_2$-Nanopartikeln (Geldart-Klasse C) in der Wirbelschicht derart beeinflusst werden, dass sich ein überwiegend homogenes Wirbelbett ausbildet.

Cadoret et al. [Cadoret, L.; Reuge, N.; Pannala, S.; Syamlal, M.; Rossignol, C.; Dexpert-Ghys, J.; Coufort, C.; Caussat, B.; Silicon Chemical Vapor Deposition on macro and submicron powders in a fluidized bed, Powder Technol., 190, 185-191, 2009] beschreiben die Abscheidung von Silicium aus Monosilan $SiH_4$ auf nicht porösen sub-Mikrometer großen Titanoxidpartikeln in einem vibrierten Wirbelschichtreaktor. Durch den Vibrationseintrag konnten die Agglomerate auf den Größenbereich von 300 bis 600 $\mu$m in der Wirbelschicht begrenzt werden.

Wirbelschichtverfahren ohne Fluidisierungshilfsmittel sind für den Einlagerungsprozess/Abscheideprozess von Silicium in porösen Matrixpartikeln ungeeignet, da sich Partikel in der Größe < 20 $\mu$m nicht homogen fluidisieren lassen. Durch das inhomogene Wirbelbett lassen sich keine homogenen Produkte erzeugen.

Wirbelschichtverfahren mit Fluidisierungshilfsmitteln sind für die Kontaktierung von Partikeln der Geldart-Klasse C mit einer Gasphase nachteilig, da für die Fluidisierung der Partikel < 20 $\mu$m ein großer technischer Aufwand betrieben werden muss. Der Zusatzaufwand ist mit hohen Aufwendungen/Kosten für die Investition und Instandhaltung verbunden.

Ein weiterer Nachteil bei einer beispielhaften Silicum-Einlagerung in porösen Partikeln mittels Wirbelschichtprozess mit Fluidisierungshilfsmitteln ist, dass sich im Laufe des Prozesses die Eigenschaften der Primärpartikel, wie die Partikeldichte oder die Oberflächenbeschaffenheit, ändern. Diese wirken sich in unbekannter Weise auf die Agglomeratbildung aus, die wiederum für die Prozessfahrweise bekannt sein sollte. Homogene Prozessbedingungen über die gesamte Prozesslaufzeit können nicht sichergestellt werden.

Ein weiterer Nachteil der Wirbelschichttechnik ist, dass aufgrund der Fluidisierung der Agglomerate, bestehend aus den primären porösen Partikeln, Gasströmungen benötigt werden, die zu einem Austrag an primären Partikeln und/oder kleineren Agglomeraten führt.

Ein grundsätzlicher Nachteil der Wirbelschichttechnik ist, dass der Fluidisiergasstrom zur Ausbildung eines homogenen Wirbelbetts von der Größe der in der Wirbelschicht befindlichen Partikel bzw. Agglomerate abhängt. Hierdurch sind die Menge an zudosiertem Reaktivgas und die Kontaktzeit des Reaktivgases mit den porösen Partikeln abhängig vom Fluidisierungs- und Mischungszustand des Partikelbetts. Beispielsweise kann im Wirbelschichtprozess die Erhöhung der Kontaktzeit der Gasphase mit dem Partikelbett nur durch Verringerung der Gasgeschwindigkeit erfolgen. Die Gasgeschwindigkeit ist aber die entscheidende Größe zur Sicherstellung des Fluidisierungs- und Mischungszustands.

Eine Möglichkeit, die Nachteile der Wirbelschichttechnik zu lösen, ist die strömungsunabhängige Durchmischung der Partikelschüttung mit der Gasphase.

In DE 25 52 881 A1 wird die Behandlung von Feststoffe der Gruppe Geldart C in einem gasdurchströmten und gerührten Wirbelschichrreaktor beschieben, insbesondere eine wandgängige Rühreinrichtung in einer Prozesszone.

In US 2020/0240013 A1 wird die Abscheidung von Silicium aus einem Silicium-haltigen Gas auf Partikeln mit einer mittleren Partikelgröße im unteren Millimeterbereich in einem gerührten Bettreaktor beschrieben. Aufgrund der Partikelgröße ist davon auszugehen, dass das eingesetzte Schüttgut sehr gut fließfähig ist. Mit Hilfe des beschriebenen Apparats erfolgt der Austausch zwischen Gas und Feststoff durch den Einsatz einer zentralen Rührschnecke, durch die gleichzeitig das Reaktionsgas durch Öffnungen der gerührten Schüttung zugeführt wird. In der Anmeldeschrift wird insbesondere auf die Vorteile der Behandlung von Partikeln im Millimeterbereich abgezielt, da für Partikel in dieser Größe große Fluidisiergasströme notwendig sind, um die Partikel in den fluidisierten Zustand zu überführen.

Der eingesetzte Rührer in US 2020/0240013 A1 ist jedoch für die Umwälzung von kohäsiven Partikeln < 20 μm ungeeignet.

Aus der Fachliteratur ist bekannt, dass für die Umwälzung von Partikeln in einem gerührten Bett unterschiedlichste Rührorgane eingesetzt werden können [M. Müller, Feststoffmischen, Chemie Ingenieur Technik 2007, 79, 7]. Beispielsweise werden durch den Einsatz eines wandgängigen Wendelrührers die Partikel im Reaktor seitlich nach oben transportiert, wodurch sich ein Zirkulationsstrom mit Relativbewegung der Partikel durch nachrutschendes Material ergibt. Ein Anhaften der Partikel an der Reaktorwand wird verhindert.

Eine Kenngröße zur Beschreibung des Bewegungszustands des Partikelbetts erfolgt über die Froude-Zahl (Fr), die das Verhältnis von Zentrifugalkraft zu Gewichtskraft im rotierenden System angibt.

$$Fr = \frac{r_c \omega^2}{g}$$

Hierbei ist $r_c$ der für das System relevante charakteristische Radius. Für Systeme mit rotierendem Mischwerkzeug entspricht $r_c$ dem Außenradius des Rührorgans. Bei Systemen mit rotierender Trommel ist $r_c$ der Innenradius des Behälters. Die Kreisfrequenz $\omega = 2\pi n$ hängt von der Drehzahl $n$ des rotierenden Systems ab. Der Einfluss der Gewichtskraft wird über die Erdbeschleunigung g berücksichtigt. Bei kleinen Froude-Zahlen überwiegt der Anteil der Gewichtskraft, wodurch der radiale Materialtransport gering ist. Die Partikelschüttung wird nur unzureichend umgewälzt. Bei großen Froude-Zahlen hingegen dominiert der Anteil der Zentrifugalkraft, wodurch das Material zu stark an die Behälterwand gefördert wird. Auch hier wird die Partikelschüttung nur unzureichend umgewälzt.

Ein Parameter zur Beschreibung der Kontaktzeit zwischen der Gasphase und dem gerührten Partikelbett ist die Verweilzeit der Gasphase im Reaktor. Die mittlere Verweilzeit $t_V$ kann als Quotient aus Reaktorvolumen und dem Volumenstrom der dosierten Gasphase $\dot{V}_F$ berechnet werden:

$$t_V = \frac{V_R}{\dot{V}_F}$$

Ein weiteres wichtiges Maß zur Bewertung der homogenen Reaktionsbedingungen im gerührten Bettreaktor stellt das Verhältnis $t_u/t_v$ aus der Umwälzzeit des Partikelbetts $t_u$ zur Verweilzeit des Silicium-Präkursors $t_v$ dar. Die Umwälzzeit $t_u$ des Partikelbetts berechnet sich als Quotient aus dem Reaktorvolumen $V_R$ und dem Volumenstrom an umgewälzten Partikeln $\dot{V}_P$.

$$t_U = \frac{V_R}{\dot{V}_P}$$

Der Volumenstrom der durch das Rührorgan umgewälzten Partikel $\dot{V}_P$ wird als das durch das Rührorgan in tangentialer Richtung verdrängte Partikelvolumen pro Zeiteinheit definiert und wird allgemein durch die folgende Formel beschrieben:

$$\dot{V}_P = n\, 2\pi \sum_i \int_{r_{R,innen,i}}^{r_{R,außen,i}} r_{R,i}[h_{o,i}(r) - h_{u,i}(r)]dr_{R,i}$$

Der Volumenstrom an umgewälzten Partikeln ist das Produkt aus Drehzahl **n** und der Summe aller tangential verdrängten Volumina durch die einzelnen Rührelemente **i** des Rührorgans. Die geometrischen Maße jedes einzelnen Rührelements werden durch den Abstand der inneren Kante des Rührorgans zur Drehachse $r_{R,innen,i}$, durch den Abstand der äußeren Kante des Rührorgans zur Drehachse $r_{R,außen,i}$ sowie durch die obere Kontur $h_{o,i}(r)$ und untere Kontur $h_{u,i}(r)$ des jeweiligen Rührelements berücksichtigt.

Nimmt das Verhältnis $t_u/t_v$ Werte < 1 an, so ist der Umwälzvorgang der Partikel schneller als das Durchströmen des Betts mit einem Gas, wodurch eine gleichmäßige Verteilung des Gases mit den Partikeln vorliegt. Bei Werten des Verhältnisses $t_u/t_v$ > 1 durchströmt das Gas das gerührte Bett schneller als das Bett selbst umgewälzt wird. Hierdurch bilden sich im gerührten Bett Zonen mit unterschiedlichen Abscheidebedingungen aus, die zu einer inhomogenen Produktverteilung im Bett führen.

Vor diesem Hintergrund bestand die Aufgabe, ein Verfahren für die Kontaktierung von Partikeln der Geldart-Klasse C mit einer Gasphase bereitzustellen, welches technisch einfach umsetzbar ist und die Nachteile der oben beschriebenen Verfahren des Stands der Technik, insbesondere in Bezug auf den Austrag von Partikeln, die Reaktionszeiten und die dazu nötige Infrastruktur, nicht aufweist.

Gegenstand der Erfindung ist ein Verfahren zur Herstellung von Produkten durch Kontaktierung von Partikeln in einem gerührten Festbett mit einer Gasphase,

wobei die Behandlung der Partikel in der Prozesszone eines gasdurchströmten Reaktors stattfindet und die Partikel mittels eines wandgängigen Rührers während der Kontaktierung mit der Gasphase in der Prozesszone umgewälzt werden,
wobei das Rührwerk wandgängig ist, wenn in der Gleichung 1

$$W(h) = \frac{u_R(h)}{u_B(h)} \qquad (1)$$

für die Hälfte aller Werte von $h$ die Wandgängigkeit $W(h)$ in der Prozesszone $W(h)$ > 0,9 ist, wobei $u_R(h)$ = der äußere Umfang des Rührwerks in der Schnittfläche bei der Höhenkoordinate $h$ ist und $u_B(h)$ = der innere Umfang des Reaktors in der Schnittfläche bei der Höhenkoordinate $h$ ist.

Überraschend wurde gefunden, dass durch den erfindungsgemäßen Einsatz eines wandgängigen Rührwerkzeugs Partikel < 20 μm in einem Reaktor so umgewälzt werden und die Gasphase so dosiert wird, dass die Kontaktzeit zwischen Gasphase und Feststoff so lang ist, dass eine Reaktion des Gases mit den Partikeln mit gutem Umsatz, eine Reaktion des Gases an den Partikeln (Katalyse) mit gutem Umsatz oder eine effiziente physikalische Modifikation der Partikel erreicht wird.

Im Vergleich zum Wirbelschichtreaktor ist der gasdurchströmte gerührte Reaktor, Rührbettreaktor - englisch stirred bed reactor (SBR) -, konstruktiv einfacher aufgebaut, da im SBR eine geringere Menge an Gas komprimiert und vorgeheizt werden muss, weil das Gas nicht zum Fluidisieren genutzt wird. Es entstehen dadurch geringere Kosten für die zugehörigen Aggregate. Aufwendige Steuer- und Regelungstechnik für den Betrieb der Fluidisierhilfsmittel ist im Fall des SBR nicht notwendig. Im Vergleich zum FBR baut der SBR kleiner, da das gerührte Bett bei gleicher Masse ein geringeres Volumen einnimmt. Die spezifischen Investitionskosten sind geringer.

Im Vergleich zu GB 2580110 B2 sind mit dem erfindungsgemäßen Verfahren keine weiteren Prozessschritte notwendig.

Im Vergleich zum Wirbelschichtreaktor ist die Partikelumwälzung unabhängig von der Zuführung einer Gasphase. Es sind größere Verweilzeiten möglich, die u.a. im Fall von Reaktionen der Gasphase mit den Partikeln zu höheren Umsätzen der führen.

Durch das Rühren im erfindungsgemäßen Verfahren werden die Partikel nur umgewälzt. Die Partikel werden durch den Rührer nicht aufgewirbelt.

Der Gasstrom wird so bemessen, dass die Aufwirbelung der Partikel im erfindungsgemäßen Verfahren durch die Gasströmung minimal ist und damit der Partikelaustrag aus dem Reaktor ebenfalls minimal ist. Gleichzeitig wird der Gasstrom bevorzugt so bemessen, dass der Umsatz, im Fall von Reaktionen der Gasphase mit den Partikeln, der eingesetzten Gasphase maximal ist oder die physikalische Modifikation der Partikel effizient bei gleichzeitiger Ressourcenschonung ist.

Homogene Kontaktierungsbedingungen der Partikel mit dem Gas sind durch geeignete Parameterwahl von Rührerdrehzahl, ausgedrückt durch die dimensionslose Froude-Zahl, und durch eine geeignete Dosierrate möglich.

Gegenüber US 2020/0240013 A1 wird das erfindungsgemäße Verfahren durch den Einsatz eines wandgängigen Rührers verbessert. Durch diese Umwälzung des Partikelbetts mit dem wandgängigen Rührer wird eine ausreichend gute Makrovermischung der fluiden Phase mit der Feststoffphase realisiert, die zu einer homogenen Behandlung aller Partikel in der Feststoffphase führt.

Im Fall von Reaktionen der Gasphase mit den Partikeln, besteht ein weiterer ökonomischer Vorteil des Verfahrens im Gegensatz zum nicht erfindungsgemäßen Verfahren in einer höheren Umsetzung einer möglichen Gasphase, beispielsweise eine höhere Silicium-Ausbeute im Falle der Abscheidung von SiH$_4$ in poröse Partikel.

Mit dem erfindungsgemäßen Verfahren gemäß Anspruch 1 kann beispielsweise die Belegung von Partikeloberflächen mit einer neuen Funktionalisierung, einer Reaktion der Gasphase mit den Partikeln, eine Reaktion der Gasphase an den Partikeln (Katalyse) oder eine effiziente physikalische Modifikation der Partikel unter ständiger Umwälzung des Partikelbetts mittels eines wandgängigen Rührwerks durchgeführt werden. Das eingesetzte Partikelbett kann dabei aus sortenreinen Partikeln oder aus Partikelmischungen aufgebaut sein.

Dabei können im Rahmen des Verfahrens auch mehrere Schritte zur Vor- oder Nachbehandlung der eingesetzten Partikel erfolgen. Diese Behandlungen können entweder in einem Reaktor oder in mehreren Reaktoren oder Kolonnen durchgeführt werden. Werden aus dem Verfahren gasförmige Produkte erhalten, so kann die aus dem Prozess ausgeleitete Gasphase durch eine Auftrennung, beispielsweise durch einen Wäscher, eine Destillation oder eine Kondensation vom gewünschten Produkt abgetrennt werden.

Werden die eingesetzten Partikel in einem separaten Reaktor vorbehandelt, so kann der Transfer der Partikel in einen weiteren Reaktor oder Behälter beispielsweise durch ein Fallrohr, Stetigförderer, Strömungsförderer/Saug- oder Druckförderanlage (z.B. Vakuumförderer, Transportgebläse); Mechanische Förderer (z.B. Rollenförderer mit Antrieb, Schneckenförderer, Kreisförderer, Umlaufförderer , Becherwerk, Zellenradschleusen, Kettenförderer, Kratzerförderer, Bandförderer, Schwingförderer); Schwerkraftförderer (z.B. Rutschen, Rollenbahn, Kugelbahn, Schienenbahn),sowie mittels Unstetigförderer Flurgebunden Schienenfrei (z.B. Automatikfahrzeug, Hand-Gabelhubwagen, Elektro-Gabelhubwagen), Fahrerlose Transportsysteme (FTS), Luftkissenfahrzeug, Handkarren, Elektrokarren, Motorfahrzeug (Schlepper, Wagen, Stapler), Verschiebewagen, Verschiebehubwagen, Regalbediengerät (ohne/mit Umsetzer, kurvengängig); Flurgebunden Schienengebunden (z.B. Betriebsbahn, Gleiswagen); Flurfrei (z.B Trolleybahn), Krane (z.B. Brückenkran, Portalkran, Auslegerkran, Turmkran), Elektrohängebahn (EHB), Kleinbehältertransportanlage; Stationär (z.B. Aufzug, Hebebühne und Hubarbeitsbühne, Schrittförderer) erfolgen.

Die Wandgängigkeit **W(h)** eines Rührers in einem rotationssymmetrischen Reaktor ist als der Quotient der Umfänge zweier ebener Schnittflächen senkrecht zur Rotationsachse von zwei Rotationsflächen definiert, wobei **h** die Höhenkoordinate darstellt. Die innere Rotationsfläche wird durch einen vollständigen Umlauf des Rührwerks gebildet und ist durch den Abstand $r_R(h)$ von der Rotationsachse zur äußeren Kontur des Rührwerks charakterisiert. Zum Rührwerk zählen alle daran befestigten Bauteile. Ein ebener Schnitt an jeder beliebigen Stelle **h** der Rotationsfläche senkrecht zur Rotationsachse bildet eine Kreisfläche. Der Umfang der Schnittfläche berechnet sich mit

$$u_R(h) = 2\pi r_R(h)$$

Die äußere Rotationsfläche wird durch Rotation der inneren Kontur des Reaktors um die Rotationsachse gebildet. Sie wird durch den Abstand $r_B(h)$ beschrieben. Zur inneren Kontur des Reaktors zählen alle daran befestigten Bauteile. Der Umfang einer beliebigen Schnittfläche der äußeren Rotationsfläche senkrecht zur Rotationsachse berechnet sich mit

$$u_B(h) = 2\pi r_B(h)$$

Mit Hilfe der Umfänge ist die Wandgängigkeit wie folgt definiert:

$$W(h) = \frac{u_R(h)}{u_B(h)}$$

Im Allgemeinen kann ein Reaktor ein oder mehrere Rührwerke enthalten. Die Kontur jedes einzelnen Rührwerks bildet durch den vollständigen Umlauf eine Rotationsfläche. Diese Rotationsflächen können separat vorliegen. Bevorzugt können sie sich überlagern. Werden die einzelnen Rotationsflächen oder wird die überlagerte Rotationsfläche an beliebiger Stelle senkrecht zur Rotationsachse bzw. zu den Rotationsachsen geschnitten, so ergeben sich Figuren oder eine Figur, deren Umfang ermittelt werden kann. Ergeben sich mehrere Figuren, so wird der Gesamtumfang durch Summation der einzelnen Umfänge bestimmt.

Im Allgemeinen kann der Reaktor aus einem oder mehreren Reaktorteilen bestehen, die bevorzugt jeweils rotationssymmetrisch und miteinander verbunden sind. Die Gesamtheit aller Reaktorwände umhüllen eine Figur. Wird diese Figur an beliebiger Stelle senkrecht zur Rotationsachse der Rührwerke geschnitten, so ist der Umfang der sich ergebenden Figur bestimmbar. Die Wandgängigkeit **W(h)** wird in analoger Weise wie für den rotationssymmetrischen Reaktor berechnet.

Die Wandgängigkeit kann mit **h** variieren. Eine erfindungsgemäße Ausführung des Rührers ist gegeben, wenn die Wandgängigkeit $W(h)$ in der Prozesszone für mindestens die Hälfte aller Werte von **h** > 0,9 ist; hierfür wird $W(h_{50\%})$ definiert. In einer bevorzugten Ausführungsform ist $W(h_{50\%})$ > 0,95. In einer besonders bevorzugten Ausführungsform ist $W(h_{50\%})$ > 0,97. In einer ganz besonders bevorzugten Ausführungsform ist $W(h_{50\%})$ > 0,99. Für spezielle Fälle des Verfahrens sind auch Werte für $W(h_{50\%})$ > 1 möglich.

Ziel ist es, den Totraum der nicht vom Rührer bewegten Schüttung möglichst klein zu halten. So werden die Partikel an den beheizten Teilen des Mantels möglichst effizient in Bewegung gehalten und die Energie von der Wand in die Schüttung befördert. Außerdem wird auf diese Weise die Anhaftung von Partikeln an der Wand verhindert.

Eine Prozesszone ist der Bereich im Reaktor, in dem das gerührte Partikelbett mit der Gasphase in Kontakt gebracht wird, des Weiteren dadurch definiert, dass in diesem Bereich des Reaktors chemische oder physikalische Abläufe stattfinden, wie beispielsweise Trocknungen, Kondensationsreaktionen oder Zersetzungen der Gasphase.

Die Gasphase besteht aus einem Inertgas und/oder gegebenenfalls mindestens einer Reaktivkomponente. Die eine oder die mehreren Reaktivkomponenten können allgemein gemischt oder getrennt oder in Mischung mit Inertgasbestandteilen oder als Reinstoffe in den Reaktor eingebracht werden. Bevorzugt enthält die Reaktivkomponente einen Inertgasbestandteil von 0 bis 99%, besonders bevorzugt höchstens 50%, insbesondere bevorzugt höchstens 30% und ganz besonders bevorzugt höchstens 5%, bezogen auf den Partialdruck des Inertgasbestandteils am Gesamtdruck der Reaktivkomponente unter Normbedingungen (nach DIN 1343). Als Inertgas können beispielsweise Wasserstoff, Helium, Neon, Argon, Krypton, Xenon, Stickstoff oder Kohlendioxid oder Gemische hiervon, wie beispielsweise Formiergas, eingesetzt werden. Bevorzugt sind Argon oder insbesondere Stickstoff.

Die Reaktivkomponente kann unter den gewählten Bedingungen, beispielsweise thermischer Behandlung, reagieren und wird bevorzugt aus der Gruppe ausgewählt enthaltend

- Wasserstoff, Sauerstoff, Kohlendioxid, Kohlenmonoxid, Distickstoffmonoxid, Stickstoffmonoxid, Stickstoffdioxid, Schwefeldioxid
- Wasserdampf
- unter gewählten Bedingungen gasförmige Hydride wie $SiH_4$, $GeH_4$, $SnH_4$, $SbH_4$, $GaH_3$, $AsH_3$, $BiH_3$, $NH_3$, $PH_3$, $H_2S$, $H_2Se$
- oligomere oder polymere Silane, insbesondere lineare Silane der allgemeinen Formel $Si_nH_{n+2}$, wobei n eine ganze Zahl im Bereich 2 bis 10 umfassen kann sowie cyclische Silane der allgemeinen Formel $-[SiH_2]_n-$, wobei n eine ganze Zahl im Bereich 3 bis 10 umfassen kann
- oligomere oder polymere Germane, insbesondere lineare Germane der allgemeinen Formel $Ge_nH_{n+2}$, wobei n eine ganze Zahl im Bereich 2 bis 10 umfassen kann sowie cyclische Germane der allgemeinen Formel $-[GeH_2]_n-$, wobei n eine ganze Zahl im Bereich 3 bis 10 umfassen kann
- Halogen-haltige Präkursoren wie $Cl_2$, $F_2$, $Br_2$, Chlorsilane, Phosgen, Fluorophosgen, Chlorwasserstoff, Bromwasserstoff, Fluorwasserstoff, Bortrichlorid, Bortrifluorid, Chlordioxid, Schwefelhexafluorid, Schwefeltetrafluorid, Schwefelhexachlorid, Schwefeltetrachlorid, Siliciumtetrafluorid, Trifluorosilan
- Silikon-Präkursoren und Präkursoren für Silanisierung z.B. Silanole und Silazane
- mögliche Präkursoren für Polymerbeschichtungen aus der Gasphase sind beispielsweise p-Xylol oder seine halogenierten Derivate, Acrylate, Methacrylate, Poly-(tetrafluorethylen)- Dispersionen, Styrol, Vinylpyrrolidon, Maleinsäureanhydrid und andere.
- Kohlenwasserstoffe, vorzugsweise ausgewählt aus der Gruppe enthaltend aliphatische Kohlenwasserstoffe mit 1 bis 10 Kohlenstoffatomen, bevorzugt 1 bis 6 Kohlenstoffatomen, wie beispielsweise Methan, Ethan, Propan, Butan, Pentan, Isobutan, Hexan, Cyclopropan, Cyclobutan, Cyclopentan, Cyclohexan, Cycloheptan; ungesättigte Kohlenwasserstoffe mit 1 bis 10 Kohlenstoffatomen wie beispielsweise Ethen, Acetylen, Propen, Methylacetylen, Butylene, Butine (1-Butin, 2-Butin), Isopren, Butadien, Divinylbenzol, Vinylacetylen, Cyclohexadien, Cyclooctadien, zyklische ungesättigte Kohlenwasserstoffe, wie beispielsweise Cyclopropen, Cyclobuten, Cyclopenten, Cyclohexen, Cyclohexadien, Cyclopentadien, Dicyclopentadien oder Norbornadien, aromatische Kohlenwasserstoffe, wie beispielsweise Benzol, Toluol, p-,m-,o-Xylol, Styrol (Vinylbenzol), Ethylbenzol, Diphenylmethan oder Naphthalin, weitere aromatische Kohlenwasserstoffe, wie beispielsweise Phenol, o-, m-, p-Kresol, Cymol, Nitrobenzol, Chlorbenzol, Pyridin, Anthracen oder Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, wie beispielsweise aus Erdgaskondensaten, Erdöldestillaten oder Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

Besonders bevorzugte Reaktivkomponenten werden ausgewählt aus der Gruppe umfassend Wasserstoff, Sauerstoff, Kohlendioxid, Kohlenmonoxid, Monosilan $SiH_4$, Monogerman $GeH_4$, wobei diese allein oder auch als Mischungen zum Einsatz kommen können.

Während des Dosierens der Gasphase in die Reaktoren können die Bestandteile der Reaktivkomponente beispielsweise in gasförmiger, flüssiger oder sublimierbarer fester Form vorliegen.

Die Reaktivkomponente ist bevorzugt gasförmig, flüssig, fest, beispielsweise sublimierbar, oder eine Stoffmischung gegebenenfalls bestehend aus Stoffen in verschiedenen Aggregatzuständen. In einer Variante des Verfahrens wird die Gasphase direkt in die Schüttung der Partikel im Reaktor gegeben, beispielsweise von unten oder von der Seite oder durch einen speziellen Rührer.

In einer bevorzugten Ausführungsform werden die Temperatur, der Druck, Druckänderungen oder Differenzdruckmessungen und Gasflussmessungen im Reaktor mit gängigen Messgeräten und Messmethoden bestimmt. Nach üblicher Kalibrierung ergeben unterschiedliche Messgeräte dieselben Messergebnisse.

Der Verlauf der Behandlung der Partikel mit der Gasphase wird bevorzugt analytisch verfolgt, um das Ende der Reaktion zu erkennen und so die Reaktorbelegungszeit möglichst gering zu halten. Verfahren zur Beobachtung des Reaktionsverlaufs umfassen dabei beispielsweise Temperaturmessung zum Feststellen einer Exo- oder Endothermie zur Feststellung des Reaktionsverlaufs durch sich ändernde Verhältnisse von festen zu gasförmigen Reaktorinhaltsbestandteilen sowie durch weitere Methoden, die die Beobachtung der sich verändernden Zusammensetzung des Gasraums während der Reaktion ermöglichen. In einer bevorzugten Variante des Verfahrens wird die Zusammensetzung der Gasphase durch einen Gaschromatographen und/oder Wärmeleitfähigkeitsdetektor und/oder ein Infrarotspektroskop und/oder ein Ramanspektroskop und/oder ein Massenspektrometer bestimmt werden. In einer bevorzugten Ausführungsform werden mittels eines Wärmeleitfähigkeitsdetektors der Wasserstoffgehalt und/oder etwaig vorhandene Chlorsilane mittels eines Gaschromatographen oder Gasinfrarotspektroskops bestimmt.

In einer weiteren bevorzugten Variante des Verfahrens ist der Reaktor bzw. die Stelle des Gasaustrages mit einer technischen Möglichkeit ausgestattet, die zur Entfernung von auftretenden, kondensierbaren oder resublimierbaren Nebenprodukten oder Produkten dient.

In einer bevorzugten Ausführungsform des Verfahrens werden die Dosiervorgänge mehrfach wiederholt, wobei die jeweils beaufschlagte Gasphase jeweils gleich oder unterschiedlich sein kann, wobei auch Mischungen aus mehreren Reaktivkomponenten möglich sind. Ebenfalls kann die beaufschlagte Gasphase jeweils gleich oder unterschiedlich sein oder aus Mischungen verschiedener Reaktivkomponenten bestehen.

Als Reaktoren im Sinne dieser Anmeldung werden bevorzugt Reaktortypen ausgewählt aus der Gruppe umfassend Retortenöfen, Rohrreaktoren, Rührbettreaktoren, Rührkesselreaktoren sowie Autoklaven. Besonders bevorzugt kommen gerührte Reaktoren und Autoklaven, insbesondere bevorzugt gerührte Reaktoren und ganz besonders bevorzugt Rührkesselreaktoren zum Einsatz. Diese Reaktoren können sowohl im Unterdruck als auch im Überdruck betrieben werden. Die für das erfindungsgemäße Verfahren verwendeten Reaktoren müssen zumindest temperierbar sein. Sie können zusätzlich auch vakuumfest und druckfest sein. Sie können weiterhin mit Vorrichtungen zur Dosierung und Abführung von Gasen ausgestattet sein, sowie mit Vorrichtungen zur Einbringung und Entnahme von Feststoffen.

Ein temperierbarer Reaktor ist allgemein ein Reaktor, der so betrieben werden kann, dass die Temperatur im Inneren des Reaktors beispielweise im Bereich zwischen -40 und 1500 °C eingestellt werden kann. Kleinere Temperaturbereiche sind möglich.

Es können alle nötigen Prozessschritte im erfindungsgemäßen Reaktor durchgeführt werden, es können für Vor- und Nachbehandlungen der Partikel aber auch weitere Reaktoren anderer Bauart eingesetzt werden.

Die Partikel sowie ein mögliches entstehendes partikelförmiges, festes Produkt können allgemein als unbewegte Schüttung oder unter Durchmischung bewegt vorliegen. Eine bewegte Durchmischung der Partikel beziehungsweise des entstehenden Produkts findet gemäß Anspruch 1 statt. Während der Kontaktierung der Partikel mit den eingesetzten Gasphasen müssen die Partikel durchmischt werden. Dadurch kann beispielsweise ein homogener Kontakt aller poröser Partikel mit der Gasphase oder eine homogene Temperaturverteilung der Schüttung erreicht werden. Die Umwälzung der Partikel kann beispielsweise durch Rühreinbauten im Reaktor oder die Bewegung des gesamten Reaktors um einen Rührer herbeigeführt werden.

Die Betttemperatur der eingesetzten Partikel in der Prozesszone des mit dem wandgängigen Rührer ausgestatteten Reaktors liegt vorzugsweise im Bereich von 10 bis 2000°C, besonders bevorzugt von 30 bis 1500°C und am meisten bevorzugt von 100 bis 1000°C.

Eine weitere bevorzugte Bauform der Reaktoren sind feststehende Reaktoren mit sich bewegenden Rührorganen zur Umwälzung. Aufgabe der Umwälzung ist es, den porösen Feststoff möglichst gleichmäßig mit der Gasphase in Kontakt zu bringen. Bevorzugte Geometrien hierfür sind zylindrische Reaktoren, konische Reaktoren, kugelförmige, polyedrische, rotationssymmetrische Reaktoren oder Kombinationen davon. Die Bewegung des Rührorgans ist bevorzugt eine Rotationsbewegung. Andere Bewegungsformen sind ebenfalls geeignet. Der Antrieb des Rührorgans erfolgt bevorzugt über eine Rührwelle, wobei pro Rührwelle ein Rührorgan oder mehrere Rührorgane vorhanden sein können. In den Reaktoren können mehrere Rührwellen eingebracht werden, auf denen jeweils ein Rührorgan oder mehrere Rührorgane vorhanden sein können. Die Hauptreaktorachse ist vorzugsweise horizontal oder vertikal ausgerichtet. Die Rührwellen werden in einer weiteren bevorzugten Ausführungsform horizontal oder vertikal in einen beliebig orientierten Reaktor eingebaut. Für vertikal betriebene Reaktoren sind Bauformen bevorzugt, bei denen beispielsweise über eine Hauptrührwelle ein Rührorgan oder mehrere Rührorgane durch eine Rotationsbewegung das Schüttgut durchmischen. Es sind weiterhin Bauformen möglich, bei denen zwei oder mehr Rührwellen parallel laufen. Es sind zudem Bauformen möglich, bei denen zwei oder mehr Rührwellen nicht parallel zueinander betrieben werden. Eine weitere Bauform für einen vertikal betriebenen Reaktor ist durch die Nutzung einer Förderschnecke gekennzeichnet. Die Förderschnecke fördert bevorzugt zentral das Schüttgut. Eine weitere erfindungsgemäße Bauart ist die am Rand des Reaktors entlang rotierende Förderschnecke. Eine weitere bevorzugte Bauform ist ein planetarisches Rührsystem bzw. Spiralrührsystem. Für horizontal betriebene Reaktoren sind Bauformen bevorzugt, bei denen beispielsweise über eine Hauptrührwelle ein Rührorgan oder mehrere Rührorgane durch eine Rotationsbewegung das Schüttgut durchmischen. Es sind auch Bauformen möglich, bei denen zwei oder mehr Rührwellen parallel laufen. Es sind weiterhin Bauformen bevorzugt, bei denen zwei oder mehr Rührwellen nicht parallel zueinander betrieben werden. Für vertikal betriebene Reaktoren sind Rührorgane bevorzugt, ausgewählt aus der Gruppe enthaltend Wendelrührer, Spiralrührer, Ankerrührer oder allgemein Rührorgane, die das Schüttgut axial oder radial oder sowohl axial als auch radial fördern und eine erfindungsgemäße Wandgängigkeit $W$ aufweisen. Bei horizontal betriebenen Reaktoren sind bevorzugt mehrere Rührorgane auf einer Welle vorhanden. Erfindungsgemäße Bauformen für die Rührorgane von horizontal betriebenen Reaktoren sind Pflugschar, Paddel, Blattrührer, Spiralrührer oder allgemein Rührorgane, die das Schüttgut sowohl axial als auch radial fördern und eine erfindungsgemäße Wandgängigkeit $W$ aufweisen. Die Wandgängigkeit kann durch zusätzliche Abschaber am Rührorgan verringert werden. Neben den sich bewegenden Rührorganen sind für den Reaktor auch starre Einbauten, wie Leitbleche, möglich.

Für den Bau von Reaktor für die Durchführung des erfindungsgemäßen Verfahrens ist grundsätzlich jeder Werkstoff geeignet, der bei den jeweiligen Prozessbedingungen die notwendige mechanische Festigkeit und chemische Beständigkeit aufweist. Bezüglich der chemischen Beständigkeit kann der Reaktor sowohl aus entsprechenden Vollmaterialien als auch aus chemisch nicht beständigen Materialien (drucktragend) mit speziellen Beschichtungen oder Plattierungen medienberührter Teile bestehen. Dabei werden die Materialien erfindungsgemäß ausgewählt aus der Gruppe enthaltend:

- metallische Werkstoffe, die (gemäß DIN CEN ISO/TR 15608) für Stähle den Werkstoffgruppen 1 bis 11, für Nickel und Nickellegierungen den Gruppen 31 bis 38, für Titan und Titanlegierungen den Gruppen 51 bis 54, für Zirkonium und Zirkoniumlegierungen den Gruppen 61 und 62 und für Gusseisen den Gruppen 71 bis 76 entsprechen,
- keramische Werkstoffe aus Oxid-Keramiken im Einstoffsystem, wie beispielsweise Aluminiumoxid, Magnesiumoxid, Zirkoniumoxid, Titandioxid (Kondensatorwerkstoff) sowie Mehrstoffsysteme, wie beispielsweise Aluminiumtitanat (Mischform aus Aluminium- und Titanoxid), Mullit (Mischform aus Aluminium- und Siliciumoxid), Bleizirkonattitanat (Piezokeramik), oder Dispersionskeramiken wie mit Zirkoniumoxid verstärktes Aluminiumoxid (ZTA - Zirconia Toughened Aluminum Oxide) - $Al_2O_3/ZrO_2$),
- Nicht-Oxid-Keramiken, wie beispielsweise Carbide, zum Beispiel Siliciumcarbid und Borcarbid, Nitride, zum Beispiel Siliciumnitrid, Aluminiumnitrid, Bornitrid und Titannitrid, Boride und Silicide sowie deren Mischungen und
- Verbund- bzw. Kompositwerkstoffe, die zu den Gruppen der Teilchenverbundwerkstoffe, wie beispielsweise Hartmetall, Keramikverbunde, Beton und Polymerbeton, der Faserverbundwerkstoffe, wie beispielsweise glasfaserverstärktes Glas, Metallmatrix-Verbunde (MMC), Faserzement, kohlefaserverstärktes Siliciumcarbid, eigenverstärkte Thermoplaste, Stahlbeton, Faserbeton, Faser-Kunststoff-Verbunde, wie beispielsweise kohlenstofffaserverstärkter Kunststoff (CFK), glasfaserverstärkter Kunststoff (GfK) und aramidfaserverstärkter Kunststoff (AFK), Faser-Keramik-Verbunde (Ceramic Matrix Composites (CMC)), der Durchdringungsverbundwerkstoffe, wie beispielsweise Metall-Matrix-Verbunde (MMC), dispersionsverfestigte Aluminiumlegierungen oder dispersionsgehärtete Nickelchrom-Superlegierungen, der Schichtverbundwerkstoffe, wie beispielsweise Bimetalle, Titangraphit-Komposit, Verbundplatten und -rohre, glasfaserverstärktes Aluminium und Sandwich-Konstruktionen, und der Strukturverbundwerkstoffe zählen.

Das Verfahren eignet sich für die Manipulation aller Partikel der Geldart-Klasse C gemäß Anspruch 1. Die folgende Auflistung gibt nur Bei-spiele und schränkt den Umfang der Anmeldung nicht ein. Die eingesetzten Partikel können porös oder nicht porös sein. Die eingesetzten Partikel für das erfindungsgemäße Verfahren werden vorzugsweise ausgewählt aus der Gruppe enthaltend amorphen Kohlenstoff in Form von Hardcarbon, Softcarbon, Mesocarbon Microbeads, Naturgraphit oder synthetischem Graphit, ein- und mehrwandige Kohlenstoffnanoröhren und Graphen, Oxide wie Siliciumdioxid, Kieselgel, Aluminiumoxid, Silicium-Aluminium-Mischoxide, Magnesiumoxid, Bleioxide, Eisenoxide, Cobaltoxid, Manganoxid, Titanoxid und Zirkonoxid, Carbide wie Siliciumcarbide und Borcarbide, Nitride wie Siliciumnitride und Bornitride; Halogenide wie Aluminium Chlorid, Titanium Chlorid, Magnesium Chlorid; Salze, wie Carbonate (zum Beispiel $CaCO_3$, $MgCO_3$), Sulfate (zum Beispiel $CaSO_4$, $MgSO_4$), Sulfide (zum Beispiel $Mo_2S$) und andere keramische Werkstoffe, wie sie sich durch folgende Komponentenformel beschreiben lassen:

$Al_aB_bC_cMg_dN_eO_fSi_g$ mit $0 \leq a, b, c, d, e, f, g \leq 1$, mit mindestens zwei Koeffizienten a bis g > 0 und $a*3 + b*3 + c*4 + d*2 + g*4 \geq e*3 + f*2$.

Die keramischen Werkstoffe können beispielsweise binäre, ternäre, quaternäre, quináre, senäre oder septernäre Verbindungen sein. Bevorzugt sind keramische Werkstoffe mit folgenden Komponentenformeln:

Nichtstöchiometrische Bornitride $BN_z$ mit z = 0,2 bis 1,

Nichtstöchiometrische Kohlenstoffnitride $CN_z$ mit z = 0,1 bis 4/3,

Borcarbonitride $B_xCN_z$ mit x = 0,1 bis 20 und z = 0,1 bis 20, wobei gilt $x*3 + 4 \geq z*3$,

Bornitridooxide $BN_zO_r$ mit z = 0,1 bis 1 und r = 0,1 bis 1, wobei gilt $3 \geq r*2 + z*3$,

Borcarbonitridooxide $B_xCN_zO_r$ mit x = 0,1 bis 2, z = 0,1 bis 1 und r = 0,1 bis 1, wobei gilt: $x*3 + 4 \geq r*2 + z*3$,

Siliciumcarbooxide $Si_xCO_z$ mit x = 0,1 bis 2 und z = 0,1 bis 2, wobei gilt $x*4 + 4 \geq z*2$,

Siliciumcarbonitride $Si_xCN_z$ mit x = 0,1 bis 3 und z = 0,1 bis 4, wobei gilt $x*4 + 4 \geq z*3$,

Siliciumborocarbonitride $Si_wB_xCN_z$ mit w = 0,1 bis 3, x = 0,1 bis 2 und z = 0,1 bis 4, wobei gilt $w*4 + x*3 + 4 \geq z*3$,

Siliciumborocarbooxide $Si_wB_xCO_z$ mit w = 0,10 bis 3, x = 0,1 bis 2 und z = 0,1 bis 4, wobei gilt $w*4 + x*3 + 4 \geq z*2$,

Siliciumborocarbonitridooxide $Si_vB_wCN_xO_z$ mit v = 0,1 bis 3, w = 0,1 bis 2, x = 0,1 bis 4 und z = 0,1 bis 3, wobei gilt $v*4 + w*3 + 4 \geq x*3 + z*2$ und

Aluminiumborosilicocarbonitridooxide $Al_uB_vSi_xCN_wO_z$ mit u = 0,1 bis 2, v = 0,1 bis 2, w = 0,1 bis 4, x = 0,1 bis 2 und z = 0,1 bis 3, wobei gilt $u*3 + v*3 + x*4 + 4 \geq w*3 + z*2$.

Weitere Partikel für das erfindungsgemäße Verfahren können auch Mischoxide wie Titanate (zum Beispiel Bariumtitanat, Bleititanat, Stronitiumtitanat, Aluminiumtitanat, Perowskit und andere) oder Spinelle (zum Beispiel Magnesiospinell, Cobaltchromit, Cobaltaluminat und andere) oder Wolframate sein.

Weitere Partikel für das erfindungsgemäße Verfahren können auch Substrate mit einer oder mehreren katalytischen Spezies sein, zum Beispiel Nickel, Kupfer, Silber, Gold, Platin, Palladium oder Rhodium aber auch Metall-Verbindungen, wie Metallocene. Als Katalysatorträger kann beispielsweise Aktivkohle, Magnesiumsilicat, Aluminiumoxid oder Polymere oder Kieselgele eingesetzt werden.

Weitere Partikel für das erfindungsgemäße Verfahren können auch organischer Natur, beispielsweise Polymere wie Cowalent-Organic Frameworks (COFs), Porous Aromatic Frameworks (PAFs), Harze wie Resorcin-Formaldehyd-Harze, Melamin-Formaldehyd-Harze, Aminophenol-Formaldehyd Harze, Polymere wie Polystyrol, Polyvinylpyridin oder deren Copolymere oder metallorganischer Natur, beispielsweise Metal-Organic Framework wie MIL-101(Cr) sein.

Bevorzugt kommen als Partikel amorphe Kohlenstoffe, Siliciumdioxid, Bornitrid, Siliciumcarbid sowie Siliciumnitrid oder auch Mischwerkstoffe auf Basis dieser Materialien zum Einsatz, besonders bevorzugt ist die Verwendung von amorphen Kohlenstoffen, Bornitrid und Siliciumdioxid.

Die volumengewichtete Partikelgrößenverteilung der Partikel ist bestimmbar nach ISO 13320 mittels statischer Laserstreuung unter Anwendung des Mie-Modells mit dem Messgerät Horiba LA 950 mit Ethanol als Dispergiermedium für die porösen Partikel.

Die Partikel liegen vorzugsweise in Form von vereinzelten Partikeln vor. Die Partikel können beispielsweise isoliert oder agglomeriert vorliegen. Die Partikel sind vorzugsweise nicht aggregiert und vorzugsweise nicht agglomeriert. Aggregiert bedeutet allgemein, dass im Zuge der Herstellung der porösen Partikel zunächst Primärpartikel gebildet werden und zusammenwachsen und/oder Primärpartikel beispielsweise über kovalente Bindungen miteinander verknüpft sind und auf diese Weise Aggregate bilden. Primärpartikel sind allgemein isolierte Partikel. Aggregate oder isolierte Partikel können Agglomerate bilden. Agglomerate sind eine lose Zusammenballung von Aggregaten oder Primärpartikeln, die beispielsweise über Van-der-Waals-Wechselwirkungen oder Wasserstoffbrückenbindungen miteinander verknüpft sind. Agglomerierte Aggregate können nach gängigen Knet- und Dispergierverfahren leicht wieder in Aggregate aufgespalten werden. Aggregate lassen sich mit diesen Verfahren nicht oder nur teilweise in die Primärpartikel zerlegen. Das Vorliegen der Partikel in Form von Aggregaten, Agglomeraten oder isolierten Partikeln kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Matrixpartikeln können dagegen nicht zwischen Aggregaten oder Agglomeraten unterscheiden.

Die Partikel können eine beliebige Morphologie aufweisen, also beispielsweise splittrig, plattig, sphärisch oder auch nadelförmig sein, wobei splittrige oder sphärische Partikel bevorzugt sind. Die Morphologie kann beispielsweise durch die Sphärizität W oder die Sphärizität S charakterisiert werden. Gemäß der Definition von Wadell ist die Sphärizität W das Verhältnis aus der Oberfläche einer Kugel gleichen Volumens zur tatsächlichen Oberfläche eines Körpers. Im Falle einer Kugel hat W den Wert 1. Nach dieser Definition haben die Partikel für das erfindungsgemäße Verfahren eine Sphärizität W von vorzugsweise 0,3 bis 1,0 besonders bevorzugt von 0,5 bis 1,0, und am meisten bevorzugt von 0,65 bis 1,0.

Die Sphärizität S ist das Verhältnis aus dem Umfang eines äquivalenten Kreises mit gleicher Fläche A wie die Projektion des auf eine Fläche projizierten Partikels und dem gemessenen Umfang U dieser Projektion: $S = 2\sqrt{\pi A}/U$. Im Falle eines ideal kreisförmigen Partikels hätte S den Wert 1. Für die Partikel für das erfindungsgemäße Verfahren liegt die Sphärizität S im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität S erfolgt beispielsweise anhand von Aufnahmen einzelner Partikel mit einem optischen Mikroskop oder bei Partikeln < 10 $\mu$m bevorzugt mit einem Rasterelektronenmikroskop durch grafische Auswertung mittels einer Bildanalysesoftware, wie beispielsweise ImageJ.

Werden poröse Partikel eingesetzt, so weisen die porösen Partikel bevorzugt ein gaszugängliches Porenvolumen von $\geq$ 0,2 cm$^3$/g, besonders bevorzugt $\geq$ 0,6 cm$^3$/g und am meisten bevorzugt $\geq$ 1,0 cm$^3$/g auf.

Die Poren der porösen Partikel können beliebige Durchmesser aufweisen, also allgemein im Bereich von Makroporen (oberhalb von 50 nm), Mesoporen (2 - 50 nm) und Mikroporen (kleiner 2 nm) liegen. Die porösen Partikel können in beliebigen Mischungen verschiedener Porentypen eingesetzt werden. Porengrößenverteilung nach BJH (Gasadsorption) gemäß DIN 66134 im Mesoporenbereich und nach Horvath-Kawazoe (Gasadsorption) gemäß DIN 66135 im Mikroporenbereich; die Bewertung der Porengrößenverteilung im Makroporen-Bereich erfolgt durch Quecksilberporosimetrie nach DIN ISO 15901-1) .

Das gasunzugängliche Porenvolumen von porösen Partikeln kann mittels der folgenden Formel bestimmt werden:

Gasunzugängliches Porenvolumen = 1/Reinmaterialdichte - 1/Skelettdichte.

Dabei ist die Reinmaterialdichte eine theoretische Dichte der porösen Partikel, basierend auf der Phasenzusammensetzung oder der Dichte des Reinstoffes (Dichte des Materials als hätte es keine geschlossene Porosität). Daten zu Reinmaterialdichten lassen sich durch den Fachmann beispielsweise dem Ceramic Data Portal des National Institute of Standards entnehmen (NIST, https://srdata.nist.gov/CeramicDataPortal/scd). Beispielsweise beträgt die Reinmaterialdichte von Siliciumoxid 2,203 g/cm$^3$, die von Bornitrid beträgt 2,25 g cm$^3$, die von Siliciumnitrid beträgt 3,44 g/cm$^3$ und die von Siliciumcarbid beträgt 3,21 g/cm$^3$. Die Skelettdichte ist die tatsächliche, durch Heliumpyknometrie bestimmte Dichte der porösen Partikel (Gas-zugänglich).

Das Verfahren gemäß Anspruch 1 kann zur Kontaktierung aller erfindungsgemäßen Feststoffe mit Gasen genutzt werden. Hierbei kann das Produkt der veränderte Feststoff sein und/oder Teil des Abgases aus dem Reaktor. Veränderter Feststoff bedeutet, dass der Feststoff chemisch oder physikalisch verändert wurde. Er kann z.B. oxidiert, reduziert, kalziniert, getempert, aktiviert, passiviert, beschichtet, infiltriert, getrocknet, gekühlt oder geheizt worden sein. Die hergestellten Produkte können porös oder nicht porös vorliegen.

Ohne den Umfang der Anmeldung einzuschränken, sind Beispiele für hergestellte feste Produkte: Metallpulver, Metalloxide, Mischoxide, Hydroxide, Hydrate, Silicium, Siliciumverbindungen, Silicium-Microspheres, geröstete Erze, Salze, Sulfate, Carbonate, Chloride, Oxalate, Pigmente, Silikate, Aluminiumsilikate, Ruße, Organische Stoffe oder Katalysatoren sein.

Typische Anwendungsgebiete für Produkte des Prozesses sind Batterien, in der Reifenindustrie, Aktivkohlebehandlung, Materialien für die Datenübertragung und Speicherung, Brennstoffzellen, Katalysatoren, Bekleidung, Kosmetik, Lacke, Solarindustrie und in der Siliciumindustrie.

Produkte, die mit dem Gasstrom aus dem Reaktor ausgetragen werden, können unter Normalbedingungen gasförmig oder flüssig sein.

Wird über das erfindungsgemäße Verfahren ein Feststoff als Produkt erhalten, so kann das erhaltene Material eine beliebige Morphologie aufweisen, also beispielsweise splittrig, plattig, sphärisch oder auch nadelförmig sein, wobei splittrige oder sphärische Partikel bevorzugt sind.

Gemäß der Definition von Wadell ist die Sphärizität W das Verhältnis aus der Oberfläche einer Kugel gleichen Volumens zur tatsächlichen Oberfläche eines Körpers. Im Falle einer Kugel hat W den Wert 1.

Die Sphärizität S ist das Verhältnis aus dem Umfang eines äquivalenten Kreises mit gleicher Fläche A wie die Projektion des auf eine Fläche projizierten Partikels und dem gemessenen Umfang U dieser Projektion: $S = 2\sqrt{\pi A}/U$ . Im Falle eines ideal kreisförmigen Partikels hätte S den Wert 1. Die Messung der Sphärizität S erfolgt beispielsweise anhand von Aufnahmen einzelner Partikel mit einem optischen Mikroskop oder bei Partikeln kleiner 10 $\mu$m bevorzugt mit einem Rasterelektronenmikroskop durch grafische Auswertung mittels einer Bildanalysesoftware, wie beispielsweise ImageJ.

Ein Beispiel für die Verwendung des erfindungsgemäßen Verfahrens ist die Beschichtung (englisch - coating) von Partikeln der Geldart-Klasse C. Dieser Prozess basiert auf der chemischen Gasphasenabscheidung (CVD - "chemical vapor deposition"), bei der eine gasförmiges Reaktivkomponente an der Oberfläche eines Partikels chemisch zersetzt wird und sich somit auf der Oberfläche des Partikels ein Film bildet. Die Beschichtung von Feststoffen ist ein wesentlicher Prozess für eine Vielzahl von Industrien, darunter Chemie, Pharmazie, Landwirtschaft, Kosmetik, Elektronik und Lebensmittel. Beschichtungen werden für eine Vielzahl von Zwecken angewendet, um die Freisetzung oder Auflösung von Wirkstoffen zu kontrollieren, um die Fließfähigkeit von Pulvern zu verbessern, um reaktive Stoffe zu schützen, die anfällig für Oxidation, Licht, Luft oder Feuchtigkeit sind, um mechanische Eigenschaften zu verbessern (z. B. Abriebfestigkeit und Kompressibilität) oder um den ästhetischen Reiz zu verbessern (z.B. Textur, Aussehen, Geruchs- und Geschmacksmaskierung, Farbe).

Mit diesem Verfahren können Polymerbeschichtungen erhalten werden. Dabei reagieren Dampfphasenmonomere, um reine feste Filme direkt auf einer Oberfläche zu bilden. Somit erfolgen Polymerisation und Beschichtung in einem einzigen Verarbeitungsschritt. Dies ermöglicht die Bildung von hochvernetzten Beschichtungen, welche beispielsweise über andere Verfahren aufgrund von inkompatiblen Monomeren nicht hergestellt werden können. Eine bekannte Anwendungslücke von CVD-Verfahren ist die Modifizierung von Oberflächen mit Polymeren mit begrenzter oder keiner Löslichkeit, wie dies beispielsweis bei Poly(tetrafluorethylen) (PTFE) und vielen anderen Fluorpolymeren, elektrisch leitenden Polymeren und hochvernetzten organischen Netzwerken der Fall ist.

Als unerwünschte Nebenreaktion im CVD-Verfahren kann auch die Partikelbildung aus der Gasphase stattfinden (homogene Abscheidung). Üblicherweise findet die homogene Abscheidung an den heißesten Stellen des Reaktors statt und wird in Reaktoren mit hohem Temperaturgradient stärker ausgeprägt sein.

Diese unerwünschten Nebenreaktionen können allerdings vermieden werden, wenn sich die Partikel ständig in Bewegung befinden, wie es in erfindungsgemäßen Rührbettreaktor der Fall ist. Diese Bewegung führt zu einem hohen Wärmetransport, was Temperaturgradient im Reaktor minimiert. Außerdem wird eine Anbackung der Partikel an den Reaktorwänden unterbunden.

Weitere Beispiele für die Anwendung von erfindungsgemäßen Rührbettreaktor können beliebige chemische Reaktionen von feinen Partikeln Geldart-Klasse C mit einer Gasphase umfassen. Solche chemischen Reaktionen können beispielsweise sein:

- Ätzung
- Carbonisierung und Calzinierung
- Reduktion- oder Oxidationsreaktionen
- Funktionalisierung von Feststoffen wie beispielsweise Halogenierung, Alkylierung, Nitrierung, Hydroformylierung, Silanisierung
- Gas-Gas-Reaktionen am gerührten Katalysator wie beispielsweise Herstellung von Wasserstoff aus Wasserdampf an einer Oberfläche eines Metalloxids
- Oberflächenbehandlungen wie Aktivierung, Passivierung und Reinigung
- Physikalische Prozesse wie zum Beispiel Trocknung inkl. überkritische Trocknung, Temperung
- Gas-Feststoff Reaktionen mit festen oder gasförmigen Produkten, wie beispielsweise heterogen-katalysierte chemische Reaktionen. Ein Beispiel von solchen Reaktionen kann auch die Herstellung von Polyethylen mittels Ziegler-Natta-Verfahren sein.

Bei heterogen katalysierten Reaktionssystemen, also wenn Reaktanden aus der Gasphase auf der Oberfläche eines festen Katalysators zur Reaktion werden sollen, kommt zum guten Stoff- und Wärmeübergang zwischen Partikeln und der umgebenden Gasphase noch der sehr gute makroskopische Energietransport zwischen der Partikelschüttung und der Reaktorwand dazu. Die ständige Bewegung der Partikel und die Umwälzung des gesamten Partikelbetts führt zu einem hohen Wärmetransport, wodurch Hot-Spots vermieden werden und das gesamte Bett nur schwache Temperaturgradienten aufweist.

Ein weiteres Beispiel für die Anwendung des erfindungsgemäßen Verfahrens im Rührbettreaktor kann die Herstellung von Core-Shell Strukturen ausgehend von Partikeln der Geldart-Klasse C sein, die beispielsweise als Trennmittel für HPLC- und UHPLC-Säulen eingesetzt werden können. Mit Core-Shell Partikeln gepackte Säulen liefern eine deutlich höhere Effizienz als Säulen, die mit vollporösen Partikeln des gleichen Durchmessers gepackt sind. Diese Partikelstrukturen lassen sich über das erfindungsgemäße Verfahren in vorteilhafter Weise herstellen.

Die hergestellten Produkte können mit geeigneten gängigen Analytikmethoden analysiert werden; z.B. NMR (Kernspinresonanz), EA (Elementaranalyse), IR (Infrarot Spektroskopie), Raman-Spektroskopie, Röntgenbeugung, REM (Rasterelektronenmikroskopie), qualitative Analyse, quantitative Analyse, Elektrogravimetrie, Konduktometrie, Potentiometrie, Polarographie, Partikelgrößenbestimmung, Oberflächencharakterisierungen, Chromatographie, Massenspektrometrie, Dichtebestimmungen, Stickstoffsorption, Thermogravimetrie, Kalorimetrie, ICP-Emissionsspektroskopie, Volumetrie, Spektralphotometrie, Ionenchromatographie.

Folgende analytische Methoden und Geräte wurden zur Charakterisierung eingesetzt:

Anorganische Analytik / Elementaranalyse:

Die in den Beispielen angegebenen C-Gehalte wurden mit einem Leco CS 230 Analysator ermittelt, zur Bestimmung von O- und ggf. N- bzw. H-Gehalten wurde ein Leco TCH-600 Analysator eingesetzt. Die qualitative und quantitative Bestimmung von anderen angegebenen Elementen erfolgte mittels ICP (inductively coupled plasma) Emissionspektrometrie (Optima 7300 DV, Fa. Perkin Elmer). Die Proben wurden dazu in einer Mikrowelle (Microwave 3000, Fa. Anton Paar) sauer aufgeschlossen ($HF/HNO_3$). Die ICP-OES-Bestimmung orientiert sich an der ISO 11885 "Wasserbeschaffenheit - Bestimmung von ausgewählten Elementen durch induktiv gekoppelte Plasma-Atom-Emissionsspektrometrie (ICP-OES) (ISO 11885:2007); Deutsche Fassung EN ISO 11885:2009", die zur Untersuchung saurer, wässriger Lösungen eingesetzt wird (z.B. angesäuerte Trinkwasser-, Abwasser- und andere Wasserproben, Königswasserextrakte von Böden und Sedimenten).

Partikelgrößenbestimmung:

Die Bestimmung der Partikelgrößenverteilung erfolgte im Rahmen dieser Erfindung nach ISO 13320 mittels statischer Laserstreuung mit einem Horiba LA 950. Dabei muss bei der Vorbereitung der Proben besondere Sorgfalt auf die Dispergierung der Partikel in der Messlösung aufgewendet werden, um statt der Größe von Einzelpartikeln nicht die Größe von Agglomeraten zu messen. Die Partikel wurden für die Messung in Ethanol dispergiert. Dazu wurde die Dispersion vor der Messung bei Bedarf 4 min in einem Hielscher Ultraschall-Laborgerät Modell UIS250v mit Sonotrode LS24d5 mit 250 W Ultraschall behandelt.

Oberflächenmessung nach BET:

Die spezifische Oberfläche der Materialien wurde über Gasadsorption mit Stickstoff mit einem Gerät Sorptomatic 199090 (Porotec) oder Gerät SA-9603MP (Horiba) nach der BET-Methode gemessen (Bestimmung nach DIN ISO 9277:2003-05 mit Stickstoff).

Skelettdichte:

Die Skelettdichte, d.h. die Dichte des porösen Festkörpers basierend auf dem Volumen ausschließlich der von außen gaszugänglichen Porenräume, wurde mittels He-Pyknometrie gemäß DIN 66137-2 bestimmt.

Gaszugängliches Porenvolumen:

Das gas zugängliche Porenvolumen nach Gurwitsch wurde durch Gassorptionsmessungen mit Stickstoff gemäß DIN 66134 bestimmt.

Umsatz:

Der Umsatz berechnet sich beispielsweise als Quotient aus der Stoffmenge in mol des umgesetzten, bezogen auf die Stoffmenge in mol des eingesetzten, Ausgangsstoffs (Edukt). Er zeigt in diesen Beispielen, wie viel von den eingesetzten $SiH_4$ Molekülen zu Si umgewandelt werden.

$$Umsatz\ SiH_4\ in\ \% = \frac{Stoffmenge\ an\ gewonnenem\ Si}{Stoffmenge\ an\ eingesetztem\ SiH_4} * 100\%$$

Ausbeute:

Die Ausbeute ist der Quotient aus der Masse an real gewonnenem Produkt und der theoretisch maximal möglichen Produktmasse. Die Ausbeute wird als Masseverhältnisgröße in Prozent ausgedrückt:

$$Ausbeute\ in\ \% = \frac{Tatsächliche\ Masse\ an\ Produkt}{Maximal\ mögliche\ Masse\ an\ Produkt} * 100\%$$

Sie ist ein Maß für die Verluste der durch den Gasstrom mitgerissenen Partikel.

**Beispiele**

Das eingesetzte $SiH_4$, der Qualität 4.0, wurde bei Linde GmbH erworben.
In allen Beispielen wurde der amorphe poröse Kohlenstoff als poröse Partikel eingesetzt:

- spez. Oberfläche = 1907 $m^2$/g
- Porenvolumen = 0,96 $cm^3$/g
- mittlere volumengewichtete Partikelgröße D50 = 2,95 $\mu$m
- Partikeldichte = 0,7 g/ $cm^3$
- kohäsiv, Einstufung als Geldart-Klasse: C

Umsatzberechnung für die Beispiele:

Der Umsatz berechnet sich als Quotient aus der Stoffmenge in mol des umgesetzten bezogen auf die Stoffmenge in mol des eingesetzten Ausgangsstoffs (Edukt). Er zeigt in diesen Beispielen, wie viel von den eingesetzten $SiH_4$ Molekülen zu Si umgewandelt werden.

$$Umsatz\ SiH_4\ in\ \% = \frac{Stoffmenge\ an\ gewonnenem\ Si}{Stoffmenge\ an\ eingesetztem\ SiH_4} * 100\%$$

Ausbeuteberechnung für die Beispiele:

Die Ausbeute ist der Quotient aus der Masse an real gewonnenem Produkt und der theoretisch maximal möglichen Produktmasse. Die Ausbeute wird als Masseverhältnisgröße in Prozent ausgedrückt:

$$Ausbeute\ in\ \% = \frac{Tatsächliche\ Masse\ an\ Produkt}{Maximal\ mögliche\ Masse\ an\ Produkt} * 100\%$$

Sie ist ein Maß für die Verluste der durch den Gasstrom mitgerissenen Partikel.
Folgende Reaktoren wurden bei der Durchführung der experimentellen Beispiele eingesetzt:
Der eingesetzte Reaktor für alle erfindungsgemäßen Beispiele 1 bis 5 bestand aus einem zylindrischen Unterteil (Becher) mit einem Innenradius $r_B$ = 121,5 mm sowie einer Höhe h = 512 mm und einem Deckel mit mehreren Anschlüssen (beispielsweise für die Gaszufuhr, Gasabfuhr, Temperatur- und Druckmessung) und einem flachen Boden. Einbauten an der Wand waren nicht vorhanden. Das Volumen des Reaktors betrug $V_B$ = 24 l. Der Umfang einer beliebigen Schnittfläche der Rotationsfläche, die sich durch Rotation der inneren Reaktorkontur um die Rotationsachse ergab, berechnet sich zu 763,4 mm. Der eingesetzte Rührer war ein mehrflügliger Wendelrührer mit einem Radius von $r_R$ = 119,5 mm. Durch den vollständigen Umlauf des Wendelrührers ergibt sich eine Rotationsfläche. Der Umfang einer beliebigen Schnittfläche senkrecht zur Rotationsachse dieser Rotationsfläche ergibt sich zu 750,8 mm. Aus den beiden Umfängen ergibt sich eine Wandgängigkeit von **W** = 0,98. Die Höhe der Wendel entsprach ca. 75% der lichten Höhe des Reaktorinnenraums. Der Reaktor wurde so weit gefüllt, dass die Höhe des gerührten Partikelbetts geringer als die Höhe der Wendel ist. Somit befindet sich die Prozesszone zu mehr als 50 % im Bereich des Rührers mit der Wandgängigkeit **W** = 0,98. Der Becher wurde mit einer Mantelheizung elektrisch beheizt. Die Temperaturmessung erfolgte grundsätzlich zwischen der Heizung und dem Reaktor. Die Gaszufuhr erfolgte in der unteren Hälfte (125 mm über dem Reaktorboden) der Schüttung über zwei Tauchrohre mit einem Außendurchmesser von d = 6 mm, die das Gas direkt in die bewegte Schüttung einbrachten.
Im nicht erfindungsgemäßen Vergleichsbeispiel 1 wurde ein Wirbelschichtreaktor eingesetzt, der aus einem zylindrischen Teil mit einem Außendurchmesser von 160 mm und mit einer Höhe von 1200 mm bestand. Der zylindrische Teil setzte sich aus einer Bodenkammer und dem eigentlichen Wirbelschichtreaktor zusammen. Die beiden Teile waren durch den gasdurchlässigen Boden voneinander getrennt. Oberhalb des zylindrischen Reaktorteils schloss sich ein Reaktorteil mit Querschnittserweiterung auf die doppelte Querschnittsfläche im Vergleich zum zylindrischen Reaktorteil an. Am oberen Ende des Reaktors befand sich ein Deckel mit Filterelementen für den Gasaustritt. Die Einstellung der Reaktionstemperatur erfolgte über die Beheizung der Reaktorwand, wobei die Höhe des beheizten Bereichs 80% der zylindrischen Länge beginnend am gasdurchlässigen Boden betrug. Als Maß für die Prozesstemperatur wurde die Temperatur zwischen Heizmantel und Reaktoraußenwand genutzt. Die Heizung erfolgte elektrisch. Das Fluidisiergas wurde entsprechend vor dem Einströmen in den Wirbelschichtreaktor mit einem Gaserhitzer vorgeheizt. Die Pulsation des Fluidisiergasstroms wurde durch den Einsatz eines direkt gesteuerten Magnetventils realisiert. Als Maß für die Qualität der Wirbelschicht wurde der Fluidisierungsindex herangezogen.

In Vorversuchen wurden durch Druckverlustmessungen des Wirbelbetts die minimale Fluidisiergeschwindigkeit ermittelt.

**Definition Fluidisierungsindex:** Der Fluidisierungsindex *FI* ist definiert als das Verhältnis aus dem gemessenen Druckverlust über der Wirbelschicht $\Delta\boldsymbol{p_{WS,Messung}}$ und dem theoretisch maximal erreichbaren Druckverlust $\Delta\boldsymbol{p_{WS,th}}$ und wird durch die folgende Gleichung 1 berechnet:

$$FI = \frac{\Delta p_{WS,Messung}}{\Delta p_{WS,th}}$$

Der theoretisch maximal erreichbare Druckverlust berechnet sich unter Vernachlässigung der Gasdichte aus der Masse der Schüttung $\boldsymbol{m_S}$, der Erdbeschleunigung $\boldsymbol{g}$ und der Reaktorquerschnittsfläche $A_{WS}$ zu $\Delta\boldsymbol{p_{WS,th}} = \boldsymbol{m_S} \cdot \boldsymbol{g}/\boldsymbol{A_{WS}}$.

Bei einer vollständig fluidisierten Wirbelschicht nimmt der Fluidisierungsindex Werte von maximal 1 an.

**Bestimmung des Fluidisierungsindexes:** Der Fluidisierungsindex ist das Verhältnis aus gemessenem Druckverlust und dem theoretisch maximal möglichen Druckverlust. Es ist notwendig, für die Ermittlung des Fluidisierungsindexes den Druckverlust des Wirbelbettes messtechnisch zu erfassen. Die Druckverlustmessung erfolgt als Differenzdruckmessung zwischen unterem und oberem Ende der Wirbelschicht. Das Differenzdruckmessgerät wandelt die auf Membranen erfassten Drücke in digitale Werte um und zeigt die Druckdifferenz an. Die Druckmessleitungen sind so auszuführen, dass sie unmittelbar oberhalb des gasdurchlässigen Bodens und unmittelbar oberhalb des Wirbelbetts angeordnet sind. Für die Bestimmung des Fluidisierungsindexes ist zusätzlich die genaue Erfassung des Gewichts der eingebrachten Partikelschüttung notwendig. Siehe auch [VDI-Wärmeatlas 11. Auflage, Abschnitt L3.2 Strömungsformen und Druckverlaust in Wirbelschichten, S. 1371 - 1382, Springer Verlag, Berlin Heidelberg, 2013].

**Bestimmung der minimalen Fluidisiergeschwindigkeit:** Die minimale Fluidisiergeschwindigkeit ist die auf die leere Reaktorquerschnittsfläche bezogene Fluidisiergasgeschwindigkeit, bei der die Partikelschüttung vom durchströmten Festbett in eine Wirbelschicht übergeht. Durch simultane Messung des geregelten Fluidisiergasstroms mittels Massedurchflussmesser und des Druckverlusts der Wirbelschicht mittels digitalem Differenzdruckmesser kann die minimale Fluidisiergeschwindigkeit ermittelt werden. Durch Kenntnis der Querschnittsfläche des Reaktors kann aus dem gemessenen Fluidisiergasstrom die Fluidisiergasgeschwindigkeit berechnet werden. Der aufgezeichnete Verlauf des Druckverlusts über der Fluidisiergasgeschwindigkeit wird als Wirbelschichtkennlinie bezeichnet. Es ist darauf zu achten, dass die Wirbelschichtkennlinie ausgehend von einer hohen Fluidisiergasgeschwindigkeit durch schrittweise Verkleinerung dieser Geschwindigkeit aufgenommen wird. Bei reiner Festbettdurchströmung nimmt der Druckverlust linear zu. Der zugehörige Fluidisierungsindex *FI* ist kleiner als eins. Bei einer vollausgebildeten Wirbelschicht ist der gemessene Druckverlust konstant. Der zugehörige Fluidisierungsindex *FI* ist gleich eins. Im Übergang beider Bereiche liegt der Zustand der Minimalfluidisierung vor. Die zugehörige, auf die leere Reaktorquerschnittsfläche bezogene Fluidisiergasgeschwindigkeit ist gleich der minimalen Fluidisiergeschwindigkeit. Ist der Übergang vom Festbett zur Wirbelschicht durch einen Bereich charakterisiert, wird der Schnittpunkt der extrapolierten Festbettkennlinie und der extrapolierten Wirbelschichtkennlinie als Punkt der Minimalfluidisierung definiert. Siehe auch [VDI-Wärmeatlas 11. Auflage, Abschnitt L3.2 Strömungsformen und Druckverlust in Wirbelschichten, S. 1371 - 1382, Springer Verlag, Berlin Heidelberg, 2013].

Im nicht erfindungsgemäßen Vergleichsbeispiel 2 wurde ein indirekt beheizter Drehrohrofen eingesetzt. Dieser Drehrohrofen verfügte über ein um seine Längsachse rotierbares Drehrohr aus Quarzglas mit dem Durchmesser von 20 cm und beheizbarem Volumen von 30 L. Als Maß für die Prozesstemperatur wurde die Außenwandtemperatur des Quarzrohres genutzt. Die Heizung erfolgte elektrisch und konnte durch 3 Zonen geregelt werden. Zur Durchführung der Silicium-Infiltrationsreaktionen sollte das Drehrohr gasdicht abgeschlossen sein.

**Vergleichsbeispiel 1 (nicht erfindungsgemäß):** Herstellung eines Silicium-enthaltenden Materials im Wirbelschichtreaktor mit pulsiertem Fluidisiergasstrom

Es wurden 500 g eines amorphen Kohlenstoffs als poröses Ausgangsmaterial (spez. Oberfläche = 1907 $m^2$/g, Porenvolumen = 0,96 $cm^3$/g, mittlere volumengewichtete Partikelgröße $D_{50}$ = 2,95 pm, Partikeldichte = 0,7 g/$cm^3$, Partikel der Geldart-Klasse C) in den Reaktor eingefüllt.

Die Partikelschüttung wurde mit einem aus Stickstoff bestehenden Fluidisiergas fluidisiert, wobei die Gasmenge so festgelegt wurde, dass mindestens das 3-fache der in den Vorversuchen ermittelten, minimalen Fluidisierungsgeschwindigkeit vorlag. Gleichzeitig wurde mit Hilfe des Magnetventils der Gasstrom zum Schwingen angeregt, wobei die Frequenz zwischen der Offen- und Geschlossenstellung des Ventils 3 Hz betrug. Anschließend wurde die Temperatur im Reaktor auf die Solltemperatur von 430 °C erhöht. Aufgrund der Temperaturerhöhung wurde der Fluidisiergasstrom derart angepasst, dass der Fluidisierungsindex einen Wert > 0,95 annahm.

Nach Erreichen der Solltemperatur von 430°C wurde das Fluidisiergas durch Reaktivgas enthaltend 10 Vol.-% $SiH_4$ ersetzt. Die Pulsation des Gasstroms mit der Frequenz zwischen der Offen- und Geschlossenstellung des Ventils von 3 Hz blieb während und nach dem Wechsel der Fluidisiergase bestehen und weiterhin wurden sowohl die Werte für den Fluidisierungsindex von $FI$ = 0,98 als auch aufgrund der Dichteänderung der porösen Ausgangsmaterialien während der Abscheidung des Siliciums die Gasmenge des Fluidisiergases derart angepasst, dass die Werte des Fluidisierungsindexes stets größer als 0,95 waren.

Nach einer Reaktionszeit von 2,6 Stunden wurde das Fluidisiergas wieder auf einen gepulsten Stickstoffstrom umgestellt. Die Heizleistung wurde reduziert. Nach Erreichen einer Temperatur von 50°C wurde der Fluidisiergasstrom auf ein Fluidisiergas, bestehend aus 5 Vol.-% Sauerstoff, in Stickstoff umgeschaltet und für 60 min gehalten, um etwaige auf der Oberfläche des erhaltenden Produkts vorhandene, reaktive Gruppen kontrolliert abreagieren zu lassen. Anschließend wurde der Reaktor auf Raumtemperatur abgekühlt.

Nach Beendigung des Prozesses wurden 990 g eines schwarzen Feststoffs aus dem Reaktor ausgeschleust. Das gewonnene Silicium-enthaltende Material wurde in ein zylindrisches Gefäß gefüllt und in einem Rhönradmischer homogenisiert. Die durch den Wirbelschichtprozess gebildeten Agglomerate ließen sich durch Siebung beseitigen. Die Reaktionsbedingungen zur Herstellung sowie die Materialeigenschaften der Silicium-Kohlenstoff-Kompositpartikel sind in Tabelle 2 zusammengefasst.

**Vergleichsbeispiel 2 (nicht erfindungsgemäß)**: Herstellung eines Silicium-enthaltenden Materials nach einem nicht erfindungsgemäßen Verfahren im drehenden Rohrreaktor

Ein drehender Rohrreaktor (Bauch-Volumen 30 L) wurde mit 0,9 kg des gleichen porösen Kohlenstoffs wie in dem Vergleichsbeispiel 1 (spez. Oberfläche = 1907 $m^2$/g, Porenvolumen = 0,96 $cm^3$/g, mittlere volumengewichtete Partikelgröße $D_{50}$ = 2,95 μm, Partikeldichte = 0,7 g/$cm^3$, Partikel der Geldart-Klasse C) beladen. Nach Inertisierung mit Stickstoff wurde der Reaktor auf 430°C erhitzt. Bei Erreichen der Reaktionstemperatur wurde das Reaktivgas (10% $SiH_4$ in $N_2$, Dosierrate 2,3 $m^3$/h) für 8,5 h durch den Reaktor geleitet, dabei wurde der Reaktor mit der Drehzahl ca. 7 Umdrehungen pro Minute gedreht. Der Reaktor wurde anschließend mit Inertgas gespült. Vor der Entnahme aus dem Reaktor wurde das Produkt unter Inertgas auf Raumtemperatur abgekühlt. Die Reaktionsbedingungen zur Herstellung sowie die Materialeigenschaften der Silicium-Kohlenstoff-Kompositpartikel sind in Tabelle 2 zusammengefasst.

**Beispiele 1-5 (erfindungsgemäß)**: Herstellung von Silicium-enthaltenden Materialien nach dem erfindungsgemäßen Verfahren unter Einsatz von Monosilan $SiH_4$ als Silicium-Präkursor unter Normaldruck (0,1 MPa) (die jeweiligen Werte für die Parameter **A-D** sowie die Beispielnummer sind in Tabelle 1 zusammengefasst)

Es wurden 2,4 kg des gleichen porösen Kohlenstoffs, wie in dem Vergleichsbeispiel 1 und 2 (spez. Oberfläche = 1907 $m^2$/g, Porenvolumen = 0,96 $cm^3$/g, mittlere volumengewichtete Partikelgröße $D_{50}$ = 2,95 pm, Partikeldichte = 0,7 g/$cm^3$, Partikel der Geldart-Klasse C) in den erfindungsgemäßen Reaktor mit dem Rührwerk (Volumen 24 L, Durchmesser 25 cm), eingefüllt. Anschließend wurde Reaktor auf 350°C für 240 Minuten temperiert und mit Stickstoff inertisiert.

In Folge wurde der Reaktor auf 430°C erhitzt. Bei Erreichen der Reaktionstemperatur wurde das Reaktivgas mit **Konzentration A Dosierrate B** für **C Stunden** durch den Reaktor geleitet. Die Gasphase wurde dem Reaktor zugeführt, während das Partikelbett durch ein erfindungsgemäßes wandgängiges Rührwerk, einem Wendelrührer, so umgewälzt wurde, dass das **Verhältnis aus Umwälzzeit zur mittleren Verweilzeit der Reaktivkomponente D** war und der Bewegungszustand der Schüttung mit Froude-Zahl 3 beschrieben werden konnte.

Anschließend wurde das Silicium-enthaltende Material innerhalb von 120 Minuten auf eine Temperatur von 70°C abgekühlt. Anschließend wurde der Reaktor eine Stunde mit Stickstoff, eine Stunde mit Magerluft mit einem Sauerstoffanteil von 5 Vol.-%, eine Stunde mit Magerluft mit einem Sauerstoffanteil von 10 Vol.-%, eine Stunde mit Magerluft mit einem Sauerstoffanteil von 15 Vol.-% und anschließend eine Stunde mit Luft gespült. Abschließend wurde das Produkt aus dem Reaktor entnommen.

**Tabelle 1** Versuchsparameter für die erfindungsgemäßen Beispiele 1 bis 5

| Versuchsparamet er | Bezeichnung | Beispielnummer | | | | |
|---|---|---|---|---|---|---|
| | | Bsp1 | Bsp2 | Bsp3 | Bsp4 | Bsp5 |
| $SiH_4$ Konz, mol.-% | A | 10 | 50 | 50 | 100 | 100 |
| Dosierrate, $m^3$/h | B | 6,1 | 1,2 | 4,6 | 0,6 | 0,3 |

(fortgesetzt)

| Versuchsparamet er | Bezeichnung | Beispielnummer | | | | |
|---|---|---|---|---|---|---|
| | | Bsp1 | Bsp2 | Bsp3 | Bsp4 | Bsp5 |
| Dauer $SiH_4$ Zugabe, h | C | 9,7 | 6,9 | 2,5 | 5,3 | 8,5 |
| Verhältnis t Umwälzzeit / t Verweilzeit | D | 0,075 | 0,015 | 0,015 | 0,007 | 0,007 |

Die Reaktionsbedingungen zur Herstellung sowie die Materialeigenschaften der Silicium-Kohlenstoff-Kompositpartikel sind in der folgenden Tabelle 2 zusammengefasst.

Tabelle 2

| | Vbsp 1* | Vbsp 2* | Bsp 1 | Bsp 2 | Bsp 3 | Bsp 4 | Bsp 5 |
|---|---|---|---|---|---|---|---|
| Reaktortyp | Wirbelschicht pulsiert | Drehrohrofen | SBR | SBR | SBR | SBR | SBR |
| Menge Edukt, kg | 0,5 | 0, 9 | 2,4 | 2,4 | 2,4 | 2,4 | 2,4 |
| $SiH_4$ Konz, mol.-% | 10 | 10 | 10 | 50 | 50 | 100 | 100 |
| Manteltemperatur bei $SiH_4$ Zugabe, °C | 430 | 430 | 430 | 430 | 430 | 430 | 430 |
| Dauer der $SiH_4$ Zugabe, h | 2, 6 | 9, 9 | 9, 7 | 6, 9 | 2,5 | 5,3 | 8,5 |
| Reaktorvolumen, L | 20 | 30 | 24 | 24 | 24 | 24 | 24 |
| Reaktordurchmesser, m | 0,15 | 0,20 | 0,25 | 0,25 | 0,25 | 0,25 | 0,25 |
| Fr-Zahl | n.A. | 0,005 | 3 | 3 | 3 | 3 | 3 |
| Verhältnis t Umwälzzeit / t Verweilzeit | n.a. | n.a. | 0,075 | 0,015 | 0,015 | 0,007 | 0,007 |
| Umsatz $SiH_4$, % | 20 | 40 | 41 | 60 | 40 | 75 | 98 |
| Menge Produkt, kg | 0,99 | 1,84 | 5,67 | 5,74 | 5,51 | 5,66 | 5,80 |
| Produkt Ausbeute, % | 80 | 82 | 95 | 96 | 92 | 95 | 97 |
| Partikelaustrag | ja | ja | nein | nein | nein | nein | nein |
| Si, Gew.-% | 56 | 56,5 | 56 | 57 | 55 | 56 | 57 |
| O, Gew.-% | 3,8 | 3,04 | 2,1 | 2,64 | 3,62 | 2,64 | 2,84 |
| BET m²/g | 11 | 10 | 23 | 26,6 | 43,6 | 26,8 | 23, 8 |
| *nicht erfindungsgemäß | | | | | | | |

Unabhängig von den eingesetzten Reaktoren können gleiche charakteristische Materialkennwerte erhalten werden. Es konnten allerdings $SiH_4$-Umsatz, Produktausbeute und Reaktionszeit im erfindungsgemäßen Reaktorsystem im Vergleich zu Wirbelschicht und Drehrohrofen verbessert werden.

**Patentansprüche**

1. Verfahren zur Herstellung von Produkten durch Kontaktierung von Partikeln der Geldart-Klasse C mit einer Partikelgröße $d_{90} < 20$ $\mu$m in einem gerührten Festbett mit einer Gasphase, wobei die Behandlung der Partikel in einer Prozesszone eines gasdurchströmten Reaktors stattfindet, wobei die Prozesszone der Bereich im Reaktor ist, in dem das gerührte Partikelbett mit der Gasphase in Kontakt gebracht wird, und die Partikel mittels eines wandgängigen Rührers während der Kontaktierung mit der Gasphase in der Prozesszone umgewälzt werden,

   wobei das Rührwerk wandgängig ist, wenn in der Gleichung 1

$$W(h) = \frac{u_R(h)}{u_B(h)} \qquad (1)$$

für die Hälfte aller Werte von **h** die Wandgängigkeit **W(h)** in der Prozesszone **W(h)** > 0, 9 ist, wobei $u_R(h)$ = der äußere Umfang des Rührwerks in der Schnittfläche bei der Höhenkoordinate **h** ist und $u_B(h)$ = der innere Umfang des Reaktors in der Schnittfläche bei der Höhenkoordinate **h** ist.

2. Verfahren nach Anspruch 1, bei dem die Prozesszone des Reaktors rotationssymmetrisch ist, wobei das Rührwerk wandgängig ist, wenn in der Gleichung 1

$$W(h) = \frac{u_R(h)}{u_B(h)} \qquad (1)$$

wobei

**W(h)** = die Wandgängigkeit eines Rührwerks in einem rotationssymmetrischen Reaktor, definiert als der Quotient der Umfänge zweier ebener Schnittflächen senkrecht zur Rotationsachse von zwei Rotationsflächen, wobei **h** die Höhenkoordinate darstellt,
$u_R(h)$ = der Umfang der inneren Schnittfläche der nach der Gleichung 2

$$u_R(h) = 2\pi r_R(h) \qquad (2)$$

an mehreren beliebigen Stellen **h** der Rotationsfläche senkrecht zur Rotationsachse durch einen ebenen Schnitt berechneten kreisförmigen inneren Schnittfläche,
$r_R(h)$ = der Abstand von der Rotationsachse zur äußeren Kontur des Rührwerks, wobei zum Rührwerk alle daran befestigten Bauteile zählen,
$u_B(h)$ = der Umfang der äußeren Rotationsfläche der nach der Gleichung 3

$$u_B(h) = 2\pi r_B(h) \qquad (3)$$

an jeder beliebigen Stelle **h** der Rotationsfläche senkrecht zur Rotationsachse durch einen ebenen Schnitt berechneten kreisförmigen äußeren Rotationsfläche, die durch Rotation der inneren Kontur des Reaktors um die Rotationsachse gebildet wird,
$r_B(h)$ = der Abstand der inneren Kontur des Reaktors zur Rotationsachse,
und für die Hälfte aller Werte von **h** die Wandgängigkeit **W(h)** in der Prozesszone **W(h)** > 0,9 sein muss.

3. Verfahren nach einem der vorangehenden Ansprüche, bei dem die Kontaktierung der Partikel mit der Gasphase bei 0,08 bis 5 MPa stattfindet.

4. Verfahren nach einem der vorangehenden Ansprüche, bei dem die Betttemperatur in der Prozesszone des mit dem wandgängigen Rührer ausgestatteten Reaktors im Bereich von 30 bis 1500°C liegt.

5. Verfahren nach einem der vorangehenden Ansprüche, bei dem das Verfahren in mehreren verschalteten Reaktoren durchgeführt wird.

6. Verfahren nach einem der vorangehenden Ansprüche, bei dem in der Prozesszone des Reaktors chemische oder physikalische Abläufe stattfinden.

7. Verfahren nach Anspruch 6, bei dem die chemischen Abläufe ausgewählt werden aus Belegung von Partikeloberflächen mit einer neuen Funktionalisierung, einer Reaktion der Gasphase mit den Partikeln und einer Reaktion der Gasphase an den Partikeln.

**Claims**

1. Process for producing products by contacting particles of Geldart class C having a particle size $d_{90} < 20 \, \mu m$ in a stirred fixed bed with a gas phase, wherein the treatment of the particles takes place in a process zone of a gas-traversed reactor, the process zone being the region in the reactor in which the stirred particle bed is brought into contact with the gas phase, and the particles are circulated in the process zone by means of a close-clearance stirrer during the contacting with the gas phase,

   where the stirrer mechanism is close-clearance when in equation 1

$$W(h) = \frac{u_R(h)}{u_B(h)} \qquad (1)$$

   for half of all values of $h$ the close clearance $W(h)$ in the process zone $W(h)$ is > 0.9, where $u_R(h)$ = the outer circumference of the stirrer mechanism in the sectional face at the height coordinate $h$ and $u_B(h)$ = the inner circumference of the reactor in the sectional face at the height coordinate $h$.

2. Process according to Claim 1, in which the process zone of the reactor is rotationally symmetrical, where the stirrer mechanism is close-clearance when in equation 1

$$W(h) = \frac{u_R(h)}{u_B(h)} \qquad (1)$$

   where

   $W(h)$ = the close clearance of a stirrer mechanism in a rotationally symmetrical reactor, defined as the quotient of the circumferences of two planar sectional faces perpendicular to the axis of rotation of two surfaces of rotation, with $h$ representing the height coordinate,
   $u_R(h)$ = the circumference of the inner sectional face of the circular inner sectional face calculated according to equation 2

$$u_R(h) = 2\pi r_R(h) \qquad (2)$$

   at a plurality of arbitrary points h of the surface of rotation perpendicular to the axis of rotation through a planar section,
   $r_R(h)$ = the distance from the axis of rotation to the outer contour of the stirrer mechanism, wherein the stirrer mechanism includes all components attached thereto,
   $u_B(h)$ = the circumference of the outer surface of rotation of the circular outer surface of rotation calculated according to equation 3

$$u_B(h) = 2\pi r_B(h) \qquad (3)$$

   at each arbitrary point $h$ of the surface of rotation perpendicular to the axis of rotation through a planar section, said circular outer surface of rotation being formed by rotation of the inner contour of the reactor about the axis of rotation,
   $r_B(h)$ = the distance of the inner contour of the reactor to the axis of rotation,
   and for half of all values of $h$ the close clearance $W(h)$ in the process zone $W(h)$ must be > 0.9.

3. Process according to either of the preceding claims, in which the contacting of the particles with the gas phase takes place at 0.08 to 5 MPa.

4. Process according to any of the preceding claims, in which the bed temperature in the process zone of the reactor equipped with the close-clearance stirrer is in the range from 30 to 1500°C.

5. Process according to any of the preceding claims, in which the process is conducted in two or more interconnected reactors.

6. Process according to any of the preceding claims, in which chemical or physical processes take place in the process zone of the reactor.

7. Process according to Claim 6, in which the chemical processes are selected from covering of particle surfaces with a new functionalization, a reaction of the gas phase with the particles and a reaction of the gas phase at the particles.

**Revendications**

1. Procédé de fabrication de produits par mise en contact de particules de la classe C de Geldart ayant une granulométrie $d_{90} < 20\ \mu$m dans un lit fixe agité avec une phase gazeuse, dans lequel le traitement des particules a eu lieu dans une zone de procédé d'un réacteur traversé par un gaz, la zone de procédé étant la zone du réacteur dans laquelle le lit de particules agité est mis en contact avec la phase gazeuse, et les particules étant, à l'aide d'un agitateur proche de la paroi, mises en circulation dans la zone de procédé pendant la mise en contact avec la phase gazeuse,

   dans lequel l'agitateur est proche de la paroi quand, dans l'équation 1

$$W(h) = \frac{u_R(h)}{u_B(h)} \qquad (1)$$

   la proximité à la paroi W(h) dans la zone de procédé est, pour la moitié de toutes les valeurs de *h, W(h)* > 0,9, $u_R(h)$ étant la circonférence extérieure de l'agitateur dans la surface de section pour la coordonnée verticale h et $u_B(h)$ étant la circonférence intérieure du réacteur dans la surface de section pour la coordonnée verticale *h*.

2. Procédé selon la revendication 1, dans lequel la zone de procédé du réacteur est à symétrie de révolution, dans lequel l'agitateur est proche de la paroi quand, dans l'équation 1

$$W(h) = \frac{u_R(h)}{u_B(h)} \qquad (1)$$

   dans laquelle

   *W(h)* est la proximité à la paroi d'un agitateur dans un réacteur à symétrie de révolution, définie par le rapport entre les circonférences de deux surfaces de section planes perpendiculairement à l'axe de rotation de deux surfaces de révolution, h représentant la coordonnée verticale,
   $u_R(h)$ est la circonférence de la surface de section intérieure de la surface de section intérieure circulaire calculée par l'équation 2

$$u_R(h) = 2\pi r_R(h) \qquad (2)$$

   en plusieurs points quelconques h de la surface de révolution perpendiculairement à l'axe de rotation et à travers une section plane,
   $r_R(h)$ est la distance entre l'axe de rotation et le contour extérieur de l'agitateur, tous les éléments fixés à l'agitateur comptant pour celui-ci,
   $u_B(h)$ est la circonférence de la surface de révolution extérieure de la surface de rotation extérieure circulaire calculée par l'équation 3

$$u_B(h) = 2\pi r_B(h) \qquad (3)$$

   en tout point quelconque h de la surface de révolution perpendiculairement à l'axe de rotation et à travers une section plane,

$r_B(h)$ est la distance entre le contour intérieur du réacteur et l'axe de rotation,
et pour la moitié de toutes les valeurs de h, la proximité à la surface $W(h)$ dans la zone de procédé $W(h)$ doit être > 0,9.

3. Procédé selon l'une des revendications précédentes, dans lequel la mise en contact des particules avec la phase gazeuse a lieu sous 0,08 à 5 MPa.

4. Procédé selon l'une des revendications précédentes, dans lequel la température du lit dans la zone de procédé du réacteur équipé de l'agitateur proche de la paroi est comprise dans la plage de 30 à 1 500 °C.

5. Procédé selon l'une des revendications précédentes, le procédé étant mis en œuvre dans plusieurs réacteurs reliés les uns aux autres.

6. Procédé selon l'une des revendications précédentes, dans lequel des processus chimiques ou physiques ont lieu dans la zone de procédé du réacteur.

7. Procédé selon la revendication 6, dans lequel les processus chimiques sont choisis parmi l'affectation d'une nouvelle fonctionnalisation aux surfaces des particules, une réaction de la phase gazeuse avec les particules et une réaction de la phase gazeuse sur la surface des particules.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 10147950 B2
- GB 2580110 B2
- US 7658340 B2
- DE 2552881 A1
- US 20200240013 A1

**In der Beschreibung aufgeführte Nicht-Patentliteratur**

- **D. GELDART.** Types of gas fluidization. *Powder Technology,* 1973, vol. 7, 258
- **F. SCHÜTH.** *Chem. Unserer Zeit,* 2006, vol. 40, 92-103
- Strömungsformen und Druckverlust in Wirbelschichten. VDI-Wärmeatlas. Springer Verlag, 2013, 1371-1382
- **SHABANIAN, J. ; JAFARI, R. ; CHAOUKI, J.** Fluidization of Ultrafine Powders. *IRECHE,* vol. 4 (1), 16-50
- **CADORET, L.; ; REUGE, N.; ; PANNALA, S.; ; SYAMLAL, M.; ; ROSSIGNOL, C.; ; DEXPERT-GHYS, J.; ; COUFORT, C.; ; CAUSSAT, B.** ; Silicon Chemical Vapor Deposition on macro and submicron powders in a fluidized bed. *Powder Technol.,* 2009, vol. 190, 185-191
- **M. MÜLLER.** Feststoffmischen. *Chemie Ingenieur Technik,* 2007, vol. 79, 7
- Strömungsformen und Druckverlaust in Wirbelschichten. VDI-Wärmeatlas. Springer Verlag, 2013, 1371-1382
- Abschnitt L3.2 Strömungsformen und Druckverlust in Wirbelschichten. VDI-Wärmeatlas. Springer Verlag, 2013, 1371-1382